# EUROPEAN PATENT APPLICATION

(11) **EP 4 492 443 A1**
(43) Date of publication of application: **15.01.2025**
(21) Application number: 24165821.0
(22) Date of filing: 25.03.2024
(51) Int. Cl.: H01L 21/768, H01L 21/8238, H01L 27/06, H01L 23/485, H01L 23/528

(54) **THREE-DIMENSIONAL SEMICONDUCTOR DEVICE AND METHOD OF FABRICATING THE SAME**

(30) Priority: 14.07.2023 KR 20230091587
(71) Applicant: Samsung Electronics Co., Ltd., Suwon-si, Gyeonggi-do 16677 (KR)
(72) Inventor: LEE, Sunjung, 16677 Suwon-si (KR); YOO, Donggon, 16677 Suwon-si (KR); HWANG, Jeongwon, 16677 Suwon-si (KR)
(74) Representative: Marks & Clerk LLP

(57) **Abstract**

The present disclosure relates to three-dimensional semiconductor devices. An example three-dimensional semiconductor device includes a back-side metal layer, a lower active region on the back-side metal layer, the lower active region including a lower channel pattern and a lower source/drain pattern connected with the lower channel pattern, an upper active region on the lower active region, the upper active region including an upper channel pattern and an upper source/drain pattern connected with the upper channel pattern, an interlayer insulating layer enclosing the lower and upper source/drain patterns, a penetration conductive pattern extending through the interlayer insulating layer in a vertical direction, and an inhibitor covering a side surface of a lower portion of the penetration conductive pattern. The inhibitor includes a carbon atom.

## Description

### BACKGROUND

A semiconductor device includes an integrated circuit composed of metal-oxide-semiconductor field-effect transistors (MOS-FETs). To meet an increasing demand for a semiconductor device with a small pattern size and a reduced design rule, the MOS-FETs are being aggressively scaled down. The scale-down of the MOS-FETs may lead to deterioration in operational properties of the semiconductor device. A variety of studies are being conducted to overcome technical limitations associated with the scale-down of the semiconductor device and to realize high-performance semiconductor devices.

### SUMMARY

The present disclosure relates to semiconductor devices, including a three-dimensional semiconductor device with improved electrical characteristics and a three-dimensional semiconductor device with improved productivity, and methods of fabricating the same.

In some implementations, a three-dimensional semiconductor device includes a back-side metal layer, a lower active region on the back-side metal layer, the lower active region including a lower channel pattern and a lower source/drain pattern connected to the lower channel pattern, an upper active region on the lower active region, the upper active region including an upper channel pattern and an upper source/drain pattern connected to the upper channel pattern, an interlayer insulating layer enclosing the lower and upper source/drain patterns, a penetration conductive pattern penetrating the interlayer insulating layer in a vertical direction, and an inhibitor covering a side surface of a lower portion of the penetration conductive pattern. The inhibitor includes a carbon atom.

The inhibitor may include carbon (e.g. may be formed of a carbon containing material). The inhibitor may be formed of a material that prevents or suppresses the formation of the seed layer on the inhibitor.

In some implementations, a three-dimensional semiconductor device includes a back-side metal layer, a lower active region on the back-side metal layer, the lower active region including a lower channel pattern and a lower source/drain pattern connected to the lower channel pattern, an upper active region on the lower active region, the upper active region including an upper channel pattern and an upper source/drain pattern connected to the upper channel pattern, an interlayer insulating layer enclosing the lower and upper source/drain patterns, and a penetration conductive pattern penetrating the interlayer insulating layer in a vertical direction. The penetration conductive pattern includes a seed layer and a main layer on the seed layer. A width of a bottom surface of the main layer is larger than a width of a top surface of the seed layer.

In some implementations, a three-dimensional semiconductor device includes a metal layer, an interlayer insulating layer on the metal layer, a penetration conductive pattern penetrating the interlayer insulating layer in a vertical direction, the penetration conductive pattern including a seed layer and a main layer on the seed layer, and an inhibitor covering a side surface of the seed layer. The penetration conductive pattern is electrically connected to the metal layer. A side surface of the inhibitor is aligned to a side surface of the main layer.

In some implementations, a method of fabricating a three-dimensional semiconductor device includes forming a penetration hole to penetrate an interlayer insulating layer on a device isolation layer, forming an inhibitor on an inner side surface of the penetration hole to expose a top surface of the device isolation layer to the penetration hole, forming a seed layer to cover the exposed top surface of the device isolation layer, removing an upper portion of the inhibitor, and growing a main layer using the seed layer as a seed to fill the penetration hole.

At least some of the above and other features of the invention are set out in the claims.

### BRIEF DESCRIPTION OF THE DRAWINGS

FIG. 1 is a conceptual diagram illustrating a logic cell of an example of a semiconductor device.
FIG. 2 is a conceptual diagram illustrating a logic cell of another example of a semiconductor device.
FIG. 3 is a plan view illustrating an example of a three-dimensional semiconductor device.
FIGS. 4A to 4C are example sectional views taken along lines A-A', B-B', and C-C' of FIG. 3, respectively.
FIGS. 5 to 8 are example enlarged views corresponding to a portion P1 of FIG. 4B.
FIG. 9 is an example sectional view taken along the line B-B' of FIG. 3.
FIG. 10 is an example enlarged view corresponding to a portion P2 of FIG. 9.
FIGS. 11A to 20 are diagrams illustrating an example of a method of fabricating a three-dimensional semiconductor device.
FIGS. 21 to 25 are diagrams illustrating another example of a method of fabricating a three-dimensional semiconductor device.

### DETAILED DESCRIPTION

Example implementations will now be described more fully with reference to the accompanying drawings, in which example implementations are shown.

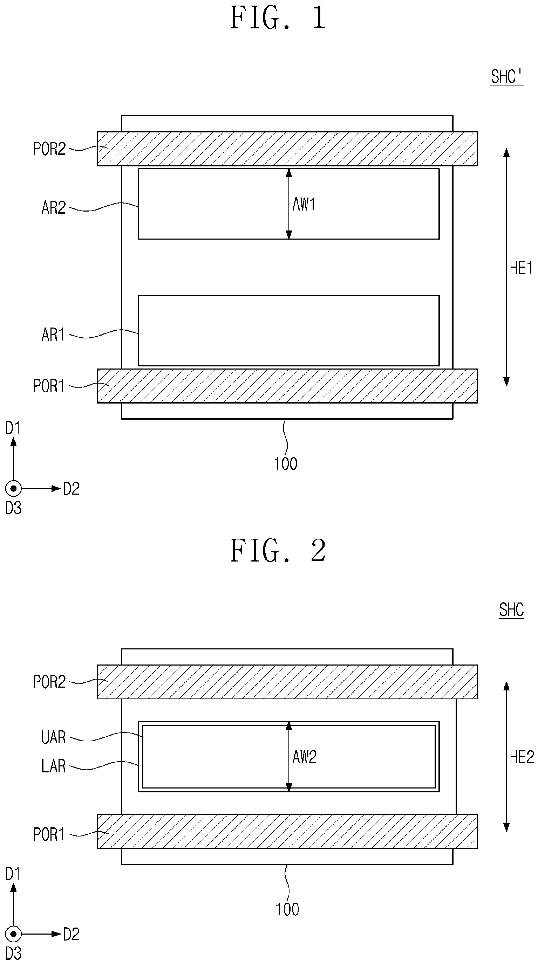

FIG. 1 is a conceptual diagram illustrating a logic cell of an example of a semiconductor device. In detail, FIG. 1 illustrates a logic cell of a two-dimensional device according to the comparative example.

Referring to FIG. 1, a single height cell SHC' may be provided. In detail, a first power line POR1 and a second power line POR2 may be provided on a substrate 100. A drain voltage VDD (e.g., a power voltage) may be applied to one of the first and second power lines POR1 and POR2. A source voltage VSS (e.g., a ground voltage) may be applied to the other of the first and second power lines POR1 and POR2. In some implementations, the source voltage VSS may be applied to the first power line POR1, and the drain voltage VDD may be applied to the second power line POR2.

The single height cell SHC' may be defined between the first and second power lines POR1 and POR2. The single height cell SHC' may include a first active region AR1 and a second active region AR2. One of the first and second active regions AR1 and AR2 may be a p-type MOSFET (PMOSFET) region, and the other of the first and second active regions AR1 and AR2 may be an n-type MOSFET (NMOSFET) region. For example, the first active region AR1 may be an NMOSFET region, and the second active region AR2 may be a PMOSFET region. That is, the single height cell SHC' may include a CMOS structure that is provided between the first and second power lines POR1 and POR2.

The semiconductor device according to the comparative example may be a two-dimensional device, in which the transistors of the front-end-of-line (FEOL) layer are two-dimensionally arranged. For example, an NMOSFET of the first active region AR1 may be spaced apart from a PMOSFET of the second active region AR2 in a first direction D1. The first direction D1 may be parallel to an upper surface (e.g. first surface 100a) of the substrate 100.

Each of the first and second active regions AR1 and AR2 may have a first width AW1 in the first direction D1. In the comparative example, a length of the single height cell SHC' in the first direction D1 may be defined as a first height HE1. The first height HE1 may be substantially equal to a distance (e.g., pitch) between the first and second power lines POR1 and POR2.

The single height cell SHC' may constitute a single logic cell. In the present specification, the logic cell may mean a logic device (e.g., AND, OR, XOR, XNOR, inverter, and so forth), which is configured to execute a specific function. In other words, the logic cell may include transistors constituting the logic device and interconnection lines connecting the transistors to each other.

In the comparative example, since the single height cell SHC' includes a two-dimensional device, the first and second active regions AR1 and AR2 may not be overlapped with each other and may be spaced apart from each other in the first direction D1. Thus, the first height HE1 of the single height cell SHC' should be defined to span both the first and second active regions AR1 and AR2, which are spaced apart from each other in the first direction D1. Thus, the first height HE1 of the single height cell SHC' may be given to be larger than at least two times the first width AW1. As a result, the first height HE1 of the single height cell SHC' in the comparative example is larger than a second height HE2 of a single height cell SHC, which will be described below. That is, the single height cell SHC' in the comparative example may have a relatively large area.

FIG. 2 is a conceptual diagram illustrating a logic cell of another example of a semiconductor device. FIG. 2 illustrates a logic cell of a three-dimensional device.

Referring to FIG. 2, a single height cell SHC, which includes a three-dimensional device with stacked transistors, may be provided. In detail, the first and second power lines POR1 and POR2 may be provided on the substrate 100. The single height cell SHC may be defined between the first power line POR1 and the second power line POR2.

The single height cell SHC may include lower and upper active regions LAR and UAR. One of the lower and upper active regions LAR and UAR may be a PMOSFET region, and the other of the lower and upper active regions LAR and UAR may be an NMOSFET region.

In some implementations, the semiconductor device may be a three-dimensional device, in which the transistors of the FEOL layer are vertically stacked. The lower active region LAR serving as a bottom tier may be provided on the substrate 100, and the upper active region UAR serving as a top tier may be stacked on the lower active region LAR. For example, the NMOSFET of the lower active region LAR may be provided on the substrate 100, and the PMOSFET of the upper active region UAR may be stacked on the NMOSFET. The lower and upper active regions LAR and UAR may be spaced apart from each other in a vertical direction (e.g., in a third direction D3). The vertical direction (e.g. the third direction D3) may be perpendicular to the first direction D1 and a second direction D2 (described later). The vertical direction may be perpendicular to the upper surface of the substrate 100. The vertical direction may define a height direction. Features or components that are described as being above other features or components may be further along the vertical direction (e.g. further from the upper surface of the substrate 100) than the other features or components. A top or upper portion of a feature or component may be a portion that is located furthest along the vertical direction. It will be appreciated that the directions described herein are relative to the structure of the semiconductor device and need not limit the orientation of the semiconductor device in use.

Each of the lower and upper active regions LAR and UAR may have a second width AW2 in the first direction D1. In some implementations, a length of the single height cell SHC in the first direction D1 may be defined as a second height HE2.

Since the single height cell SHC includes the three-dimensional device (i.e., the stacked transistors), the lower and upper active regions LAR and UAR may be overlapped with each other. Thus, the second height HE2 of the single height cell SHC may have a size spanning a single active region or may be larger than the second width AW2. As a result, the second height HE2 of the single height cell SHC may be smaller than the first height HE1 of the single height cell SHC' of FIG. 1 described above. That is, the single height cell SHC may have a relatively small area. In the three-dimensional semiconductor device, an integration density of the device may be increased by reducing an area of the logic cell.

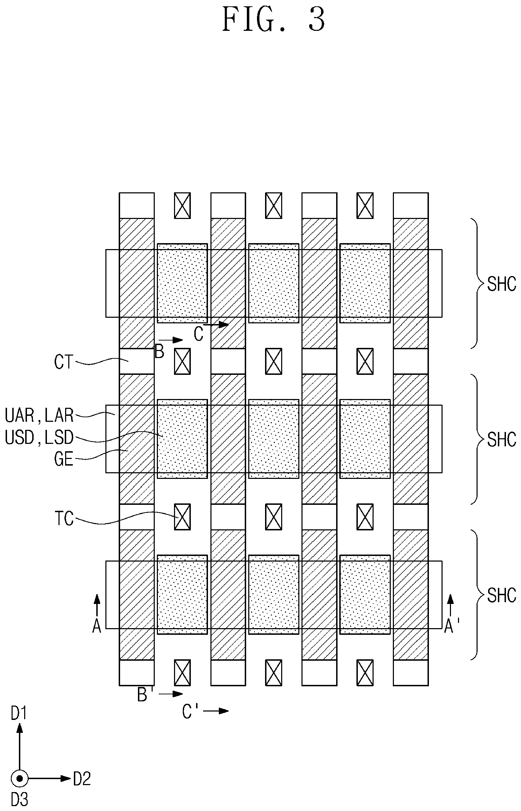

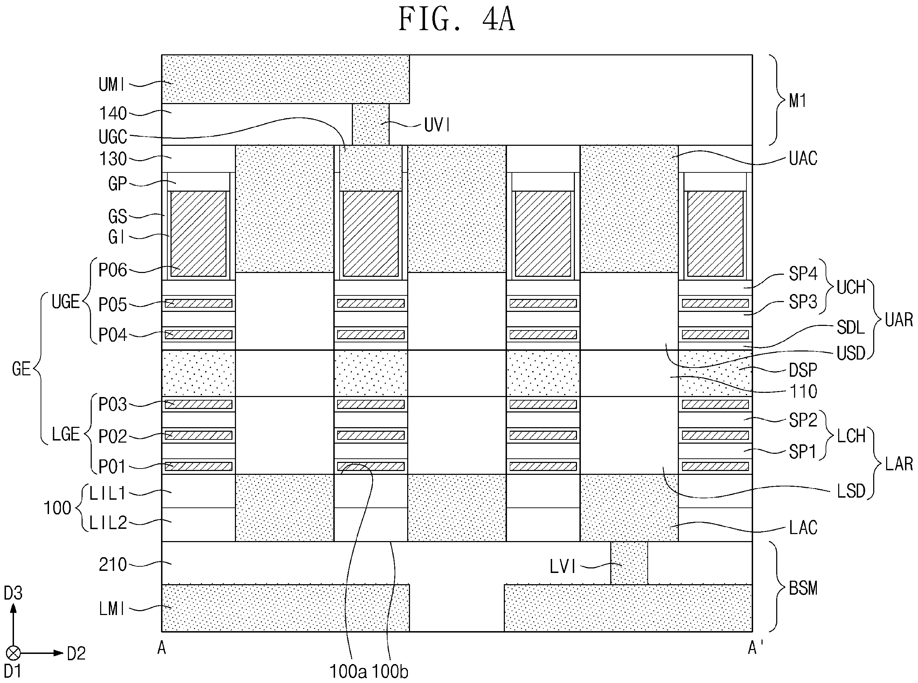

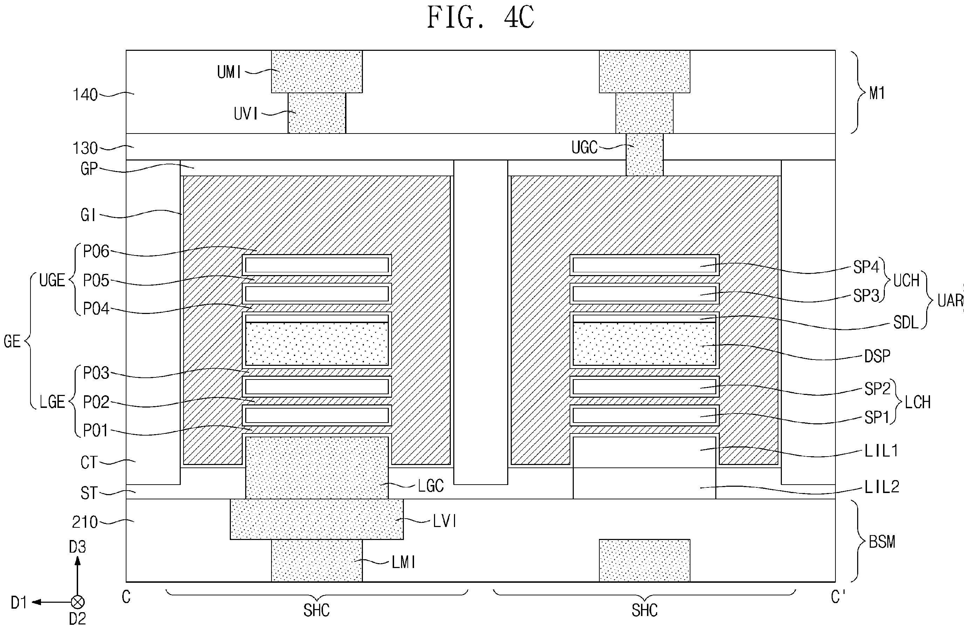

FIG. 3 is a plan view illustrating an example of a three-dimensional semiconductor device. FIGS. 4A to 4C are example sectional views taken along lines A-A', B-B', and C-C' of FIG. 3. The three-dimensional semiconductor device of FIGS. 3 and 4A to 4C may be a detailed example of the single height cell of FIG. 2.

Referring to FIGS. 3 and 4A to 4C, a single height cells SHC may be provided on the substrate 100. The substrate 100 may include a first surface 100a and a second surface 100b, which are opposite to each other. The first surface 100a may be the front surface of the substrate 100, and the second surface 100b may be the rear surface of the substrate 100. In some implementations, the substrate 100 may be an insulating substrate, which is formed of or includes a silicon-based insulating material (e.g., silicon oxide and/or silicon nitride). In some implementations, the substrate 100 may be a semiconductor substrate made of silicon, germanium, or silicon germanium.

In some implementations, the substrate 100 may include a first lower insulating layer LIL1 and a second lower insulating layer LIL2. The first lower insulating layer LIL1 may be provided on the second lower insulating layer LIL2. The first lower insulating layer LIL1 may be formed of or include at least one of silicon-based insulating materials (e.g., silicon oxide) and/or semiconductor materials (Si or SiGe). The second lower insulating layer LIL2 may be formed of or include at least one of silicon-based insulating materials (e.g., silicon oxide, silicon oxynitride, or silicon nitride).

A device isolation layer ST may be provided in the substrate 100. The device isolation layer ST may define the single height cell SHC. When viewed in a plan view, the single height cell SHC may be defined between the device isolation layers ST, which are adjacent to each other in the first direction D1. The device isolation layer ST may be interposed between a back-side metal layer BSM and a penetration conductive pattern TC, which will be described below. In some implementations, the device isolation layer ST may be formed of or include at least one of silicon-based insulating materials (e.g., silicon oxide, silicon oxynitride, or silicon nitride).

In some implementations, each of the single height cells SHC may be a logic cell constituting a logic circuit. Each of the single height cells SHC may be a logic cell, which includes a three-dimensional device previously described with reference to FIG. 2. The single height cells SHC may be arranged in the first direction D1.

Each of the single height cells SHC may include the lower and upper active regions LAR and UAR, which are sequentially stacked on the substrate 100. One of the lower and upper active regions LAR and UAR may be a PMOSFET region, and the other of the lower and upper active regions LAR and UAR may be an NMOSFET region. The lower active region LAR may be provided as a bottom tier of the FEOL layer, and the upper active region UAR may be provided as a top tier of the FEOL layer. The NMOSFET and PMOSFET of the lower and upper active regions LAR and UAR may be vertically stacked to constitute transistors, which are three-dimensionally stacked. In some implementations, the lower active region LAR may be an NMOSFET region, and the upper active region UAR may be a PMOSFET region. Each of the lower and upper active regions LAR and UAR may be a bar- or line-shaped region that extends in the second direction D2. The second direction D2 may be parallel to the upper surface of the substrate 100. The second direction D2 may intersect (e.g. may be perpendicular to) the first direction D1.

The lower active region LAR may include lower channel patterns LCH and lower source/drain patterns LSD. The lower channel pattern LCH may be interposed between a pair of the lower source/drain patterns LSD. The lower channel pattern LCH may connect the paired lower source/drain patterns LSD to each other.

The lower channel pattern LCH may include a first semiconductor pattern SP1 and a second semiconductor pattern SP2, which are stacked to be spaced apart from each other. Each of the first and second semiconductor patterns SP1 and SP2 may be formed of or include at least one of silicon (Si), germanium (Ge), or silicon germanium (SiGe). In some implementations, each of the first and second semiconductor patterns SP1 and SP2 may be formed of or include crystalline silicon. Each of the first and second semiconductor patterns SP1 and SP2 may be a nanosheet. A nanosheet may be a structure that has a thickness in the region of 1-100nm As an example, the lower channel pattern LCH may further include one or more semiconductor patterns, which are stacked and are spaced apart from the second semiconductor pattern SP2.

The lower source/drain patterns LSD may be provided on the substrate 100. Each of the lower source/drain patterns LSD may be an epitaxial pattern, which is formed by a selective epitaxial growth (SEG) process. In some implementations, a top surface of the lower source/drain pattern LSD may be higher than a top surface of the second semiconductor pattern SP2 of the lower channel pattern LCH.

The lower source/drain patterns LSD may be doped with impurities to have a first conductivity type. The first conductivity type may be an n- or p-type. In some implementations, the first conductivity type may be an n-type. The lower source/drain patterns LSD may be formed of or include silicon (Si) and/or silicon germanium (SiGe).

A first interlayer insulating layer 110 may be provided on the lower source/drain pattern LSD. The first interlayer insulating layer 110 may cover the lower source/drain patterns LSD.

A lower active contact LAC may be provided below the lower source/drain pattern LSD. The lower active contact LAC may be electrically connected to the lower source/drain pattern LSD. The lower active contact LAC may be buried in the substrate 100. The lower active contact LAC may be vertically extended from the second surface 100b of the substrate 100 to the first surface 100a. The lower active contact LAC may be formed of or include a metallic material that is selected from the group consisting of copper (Cu), aluminum (Al), ruthenium (Ru), cobalt (Co), tungsten (W), and molybdenum (Mo).

The upper active region UAR may be provided on the first interlayer insulating layer 110. The upper active region UAR may include upper channel patterns UCH and upper source/drain patterns USD. The upper channel patterns UCH may be vertically overlapped with the lower channel patterns LCH, respectively. The upper source/drain patterns USD may be vertically overlapped with the lower source/drain patterns LSD, respectively. The upper channel pattern UCH may be interposed between a pair of the upper source/drain patterns USD. The upper channel pattern UCH may connect the paired upper source/drain patterns USD to each other.

The upper channel pattern UCH may include a third semiconductor pattern SP3 and a fourth semiconductor pattern SP4, which are stacked to be spaced apart from each other. The third and fourth semiconductor patterns SP3 and SP4 of the upper channel pattern UCH may include the same semiconductor material as the first and second semiconductor patterns SP1 and SP2 of the lower channel pattern LCH. Each of the third and fourth semiconductor patterns SP3 and SP4 may be a nanosheet. As an example, the upper channel pattern UCH may further include one or more semiconductor patterns that are stacked and are spaced apart from the fourth semiconductor pattern SP4.

At least one dummy channel pattern DSP may be interposed between the lower channel pattern LCH and the upper channel pattern UCH thereon. A seed layer SDL may be interposed between the dummy channel pattern DSP and the upper channel pattern UCH.

The dummy channel pattern DSP may be spaced apart from the lower and upper source/drain patterns LSD and USD. In other words, the dummy channel pattern DSP may not be connected to any source/drain pattern. The dummy channel pattern DSP may be formed of or include at least one of semiconductor materials (e.g., silicon (Si), germanium (Ge), or silicon germanium (SiGe)) or silicon-based insulating materials (e.g., silicon oxide or silicon nitride). In some implementations, the dummy channel pattern DSP may be formed of or include at least one of the silicon-based insulating materials.

The upper source/drain patterns USD may be provided on a top surface of the first interlayer insulating layer 110. Each of the upper source/drain patterns USD may be an epitaxial pattern, which is formed by a selective epitaxial growth (SEG) process. In some implementations, a top surface of the upper source/drain pattern USD may be higher than a top surface of the fourth semiconductor pattern SP4 of the upper channel pattern UCH.

The upper source/drain patterns USD may be doped with impurities to have a second conductivity type. The second conductivity type may be different from the first conductivity type of the lower source/drain pattern LSD. The second conductivity type may be a p-type. The upper source/drain patterns USD may be formed of or include at least one of silicon germanium (SiGe) and/or silicon (Si).

A plurality of gate electrodes GE may be provided on the single height cell SHC. In detail, the gate electrodes GE may be provided on the stacked lower and upper channel patterns LCH and UCH. When viewed in a plan view, each gate electrode GE may comprise a bar-shaped pattern, which extends in the first direction D1. The gate electrode GE may be vertically overlapped with the stacked lower and upper channel patterns LCH and UCH.

The gate electrode GE may extend from the first surface 100a of the substrate 100 to a gate capping pattern GP in a vertical direction (i.e., the third direction D3). The gate electrode GE may extend from the lower channel pattern LCH of the lower active region LAR to the upper channel pattern UCH of the upper active region UAR in the third direction D3. The gate electrode GE may extend from the lowermost one of the first semiconductor patterns SP1 to the uppermost one of the fourth semiconductor patterns SP4 in the third direction D3.

The gate electrodes GE may be provided on a top surface, a bottom surface, and opposite side surfaces of each of the first to fourth semiconductor patterns SP1 to SP4. That is, the transistor may include a three-dimensional field effect transistor (e.g., MBCFET or GAAFET) in which the gate electrode GE is provided to three-dimensionally surround the channel pattern.

The gate electrode GE may include a lower gate electrode LGE, which is provided in the bottom tier of the FEOL layer (i.e., the lower active region LAR), and an upper gate electrode UGE, which is provided in the top tier of the FEOL layer (i.e., the upper active region UAR). The lower gate electrode LGE and the upper gate electrode UGE may be vertically overlapped with each other. In some implementations, the lower gate electrode LGE and the upper gate electrode UGE may be connected to each other. That is, the gate electrode GE may be a common gate electrode, in which the lower gate electrode LGE on the lower channel pattern LCH and the upper gate electrode UGE on the upper channel pattern UCH are connected to each other.

The lower gate electrode LGE may include a first inner electrode PO1 interposed between a first active pattern AP1 and the first semiconductor pattern SP1, a second inner electrode PO2 interposed between the first semiconductor pattern SP1 and the second semiconductor pattern SP2, and a third inner electrode PO3 interposed between the second semiconductor pattern SP2 and the dummy channel pattern DSP.

The upper gate electrode UGE may include a fourth inner electrode PO4 interposed between the dummy channel pattern DSP (or the seed layer SDL) and the third semiconductor pattern SP3, a fifth inner electrode PO5 interposed between the third semiconductor pattern SP3 and the fourth semiconductor pattern SP4, and an outer electrode PO6 on the fourth semiconductor pattern SP4. Each of the first to fifth inner electrodes PO1-PO5 may be an elongated electrode that extends in the first direction D1.

A pair of gate spacers GS may be disposed on opposite side surfaces of the gate electrode GE, respectively. The paired gate spacers GS may be disposed on opposite side surfaces of the outer electrode PO6, respectively. The gate spacers GS may extend along the gate electrode GE and in the first direction D1. Top surfaces of the gate spacers GS may be higher than a top surface of the gate electrode GE. The top surfaces of the gate spacers GS may be coplanar with a top surface of a second interlayer insulating layer 120. The gate spacers GS may be formed of or include at least one of SiCN, SiCON, or SiN. In some implementations, the gate spacers GS may be a multi-layered structure, which includes at least two different materials selected from SiCN, SiCON, and SiN.

The gate capping pattern GP may be provided on the top surface of the gate electrode GE. The gate capping pattern GP may extend along the gate electrode GE or in the first direction D1. For example, the gate capping pattern GP may be formed of or include at least one of SiON, SiCN, SiCON, or SiN.

A gate insulating layer GI may be interposed between the gate electrode GE and the first to fourth semiconductor patterns SP1 to SP4. The gate insulating layer GI may include a silicon oxide layer, a silicon oxynitride layer, and/or a high-k dielectric layer. In some implementations, the gate insulating layer GI may include a silicon oxide layer, which is formed to directly cover the semiconductor patterns SP1 to SP4, and a high-k dielectric layer, which is formed on the silicon oxide layer. In other words, the gate insulating layer GI may be a multi-layered structure including the silicon oxide layer and the high-k dielectric layer.

The high-k dielectric layer may be formed of or include at least one high-k dielectric material whose dielectric constant is higher than that of silicon oxide. For example, the high-k dielectric material may include at least one of hafnium oxide, hafnium silicon oxide, hafnium zirconium oxide, hafnium tantalum oxide, lanthanum oxide, zirconium oxide, zirconium silicon oxide, tantalum oxide, titanium oxide, barium strontium titanium oxide, barium titanium oxide, strontium titanium oxide, lithium oxide, aluminum oxide, lead scandium tantalum oxide, or lead zinc niobate.

The second interlayer insulating layer 120 may be provided on the upper source/drain pattern USD and the gate electrode GE. The second interlayer insulating layer 120 may cover the upper source/drain pattern USD. A third interlayer insulating layer 130 may be provided to cover the second interlayer insulating layer 120.

Upper active contacts UAC may be provided to penetrate the second and third interlayer insulating layers 120 and 130 and may be electrically connected to the upper source/drain patterns USD, respectively. A top surface of the upper active contact UAC may be coplanar with a top surface of the third interlayer insulating layer 130.

An upper gate contact UGC may be provided to penetrate the third interlayer insulating layer 130 and the gate capping pattern GP and may be electrically connected to the upper gate electrode UGE. Each of the upper active contact UAC and the upper gate contact UGC may be formed of or include a metallic material that is selected from the group consisting of copper (Cu), aluminum (Al), ruthenium (Ru), cobalt (Co), tungsten (W), and molybdenum (Mo).

A cutting pattern CT may be provided between the gate electrodes GE, which are adjacent to each other in the first direction D1. The cutting pattern CT may separate the adjacent ones of the gate electrodes GE from each other. The adjacent ones of the gate electrodes GE may be spaced apart from each other in the first direction D1 by the cutting pattern CT. The cutting pattern CT may be a bar- or line-shaped pattern that extends in the second direction D2. The cutting pattern CT may be formed of or include at least one insulating material (e.g., silicon oxide and/or silicon nitride).

A fourth interlayer insulating layer 140 may be provided on the third interlayer insulating layer 130. A first metal layer M1 may be provided in the fourth interlayer insulating layer 140. The first metal layer M1 may include upper interconnection lines UMI. The first metal layer M1 may further include an upper via UVI. The upper via UVI may electrically connect the upper interconnection line UMI to the upper active contact UAC or the upper gate contact UGC. Each of the upper interconnection line UMI and the upper via UVI may be formed of or include a metallic material that is selected from the group consisting of copper (Cu), aluminum (Al), ruthenium (Ru), cobalt (Co), tungsten (W), and molybdenum (Mo).

Additional metal layers (e.g., M2, M3, M4, and so forth) may be stacked on the first metal layer M1. The first metal layer M1 and the additional metal layers (e.g., M2, M3, M4, and so forth) thereon may constitute a back-end-of-line (BEOL) layer of the semiconductor device. The additional metal layers (e.g., M2, M3, M4, and so forth) on the first metal layer M1 may include routing lines, which are used to connect the logic cells to each other.

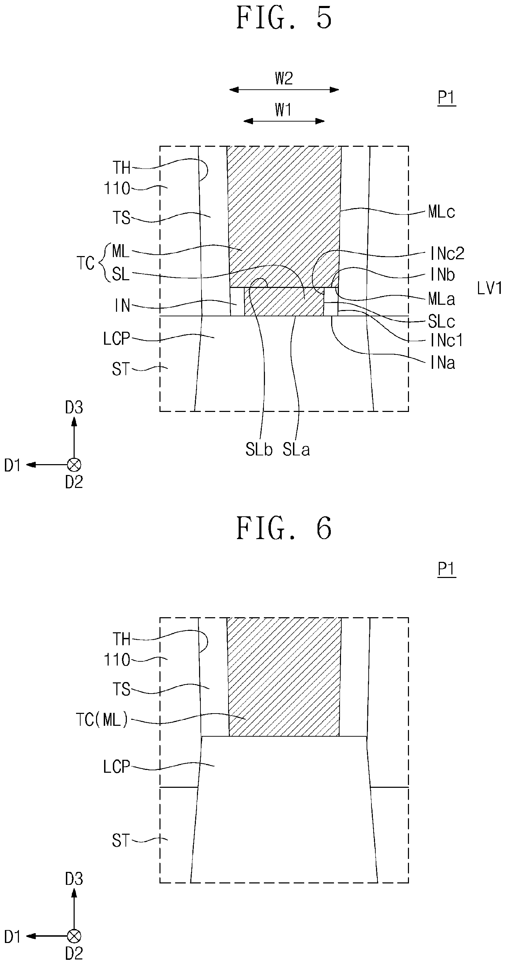

A lower interlayer insulating layer 210 may be provided below the second surface 100b of the substrate 100. The back-side metal layer BSM may be provided in the lower interlayer insulating layer 210. The back-side metal layer BSM may include lower interconnection lines LMI. The back-side metal layer BSM may further include a lower via LVI. The lower via LVI may electrically connect the lower interconnection line LMI to the lower active contact LAC, a lower gate contact LGC, or a lower contact pattern LCP, which will be described with reference to FIG. 5.

Each of the lower interconnection line LMI and the lower via LVI may be formed of or include a metallic material that is selected from the group consisting of copper (Cu), aluminum (Al), ruthenium (Ru), cobalt (Co), tungsten (W), and molybdenum (Mo).

Lower metal layers may be further stacked below the back-side metal layer BSM. In some implementations, the lower metal layers may include a power delivery network. The power delivery network may include a wiring network, which is used to apply the source and drain voltages VSS and VDD to the back-side metal layer BSM.

The source and drain voltages VSS and VDD may be applied to the back-side metal layer BSM through the power delivery network. Referring back to FIG. 4A, one of the source and drain voltages VSS and VDD may be applied to the lower source/drain pattern LSD through the lower interconnection line LMI, the lower via LVI, and the lower active contact LAC. The other of the source and drain voltages VSS and VDD may be applied from the back-side metal layer BSM to the first metal layer M1 through a power tap cell. A voltage, which is applied to the first metal layer M1 through the power tap cell, may be applied to the upper source/drain pattern USD through the upper interconnection line UMI, the upper via UVI, and the upper active contact UAC. The power tap cell may be interposed between the single height cells SHC, which are adjacent to each other.

The penetration conductive pattern TC may be provided to penetrate the interlayer insulating layers 110, 120, and 130 in a vertical direction (i.e., the third direction D3). The penetration conductive pattern TC may be provided in a penetration hole TH that is formed to penetrate the interlayer insulating layers 110, 120, and 130 in the vertical direction. In some implementations, a plurality of penetration conductive patterns TC may be arranged in various shapes when viewed in a plan view. FIG. 3 illustrates an example, in which the penetration conductive patterns TC are two-dimensionally arranged in the first and second directions D1 and D2, but the concept is not limited to this example.

The penetration conductive pattern TC may be provided to penetrate the interlayer insulating layers 110, 120, and 130 and electrically connect the first metal layer M1 to the back-side metal layer BSM. The penetration conductive pattern TC may be electrically connected to the first metal layer M1 through the upper via UVI and may be electrically connected to the back-side metal layer BSM through the lower contact pattern LCP of FIGS. 5 to 8.

The penetration conductive pattern TC may include a seed layer SL and a main layer ML on the seed layer SL. The main layer ML may be provided to have no seam therein. An inhibitor IN may be provided on a side surface of the seed layer SL of the penetration conductive pattern TC. A penetration spacer TS may be provided on a side surface of the penetration conductive pattern TC.

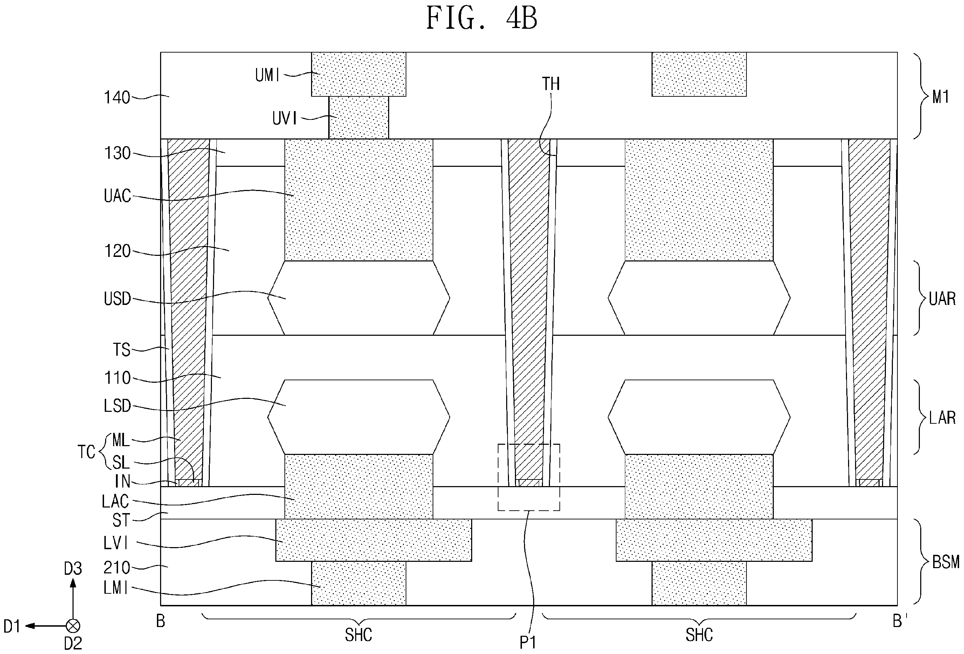

FIGS. 5 to 8 are example enlarged views corresponding to a portion P1 of FIG. 4B. Hereinafter, the penetration conductive pattern will be described in more detail with reference to FIGS. 4B, 5, 6, 7, and 8.

Referring to FIGS. 4B and 5 to 8, the penetration conductive pattern TC may include the seed layer SL on the device isolation layer ST and the main layer ML on the seed layer SL. In some implementations, the seed and main layers SL and ML may be provided to have no observable interface therebetween and may be two portions that are classified based on a first level LV1. The first level LV1 may be a vertical level of a top surface INb of the inhibitor IN. Alternatively, the seed and main layers SL and ML may be distinguished from each other based on an interface therebetween. A top surface SLb of the seed layer SL and a bottom surface of the main layer ML may be in contact with each other at the first level LV1, but the concept is not limited to this example. At the first level LV1, the top surface SLb of the seed layer SL may have a first width W1 in the first direction D1, and a bottom surface MLa of the main layer ML may have a second width W2 in the first direction D1. The second width W2 may be larger than the first width W1.

A side surface MLc of the main layer ML may be offset from a side surface SLc of the seed layer SL in either the first direction D1 or the opposite direction. The side surface MLc of the main layer ML may not be aligned to the side surface SLc of the seed layer SL. Accordingly, near the first level LV1, the side surfaces SLc and MLc of the penetration conductive pattern TC may have a stepwise profile.

The penetration conductive pattern TC may be formed of or include a metallic material that is selected from the group consisting of copper (Cu), aluminum (Al), ruthenium (Ru), cobalt (Co), tungsten (W), and molybdenum (Mo). As an example, each of the seed and main layers SL and ML may be formed of or include a metallic material that is selected from the group consisting of copper (Cu), aluminum (Al), ruthenium (Ru), cobalt (Co), tungsten (W), and molybdenum (Mo). The seed and main layers SL and ML may be formed of or include the same material or different materials. As an example, each of the seed and main layers SL and ML may be formed of or include molybdenum (Mo). As another example, the seed layer SL may be formed of or include ruthenium (Ru), and the main layer ML may be formed of or include molybdenum (Mo).

The inhibitor IN may cover the side surface SLc of the seed layer SL of the penetration conductive pattern TC. The inhibitor IN may be provided to enclose the side surface SLc of the seed layer SL. The inhibitor IN may be provided to expose at least a portion of the bottom surface of the penetration conductive pattern TC (e.g., a bottom surface SLa of the seed layer SL). The exposed bottom surface of the penetration conductive pattern TC may be in contact with the device isolation layer ST and/or a lower contact pattern LCP to be described below.

The inhibitor IN may be formed of or include a material, which is easily deposited on the penetration spacer TS but is hardly deposited (e.g. deposition is inhibited) on the device isolation layer ST in a fabrication process to be described below. As an example, the inhibitor IN may be formed of or include a carbon-containing material (e.g., Cyclohexanealdehyde (CHAD)).

The bottom surface INa of the inhibitor IN may be located at substantially the same level as the bottom surface of the penetration conductive pattern TC (e.g., the bottom surface SLa of the seed layer SL); for example, the bottom surfaces INa and SLa may be substantially coplanar with each other. The top surface INb of the inhibitor IN may be located at substantially the same level (e.g., the first level LV1) as the top surface SLb of the seed layer SL; for example, the top surfaces INb and SLb may be substantially coplanar with each other. The top surface INb of the inhibitor IN may be in contact with a portion of the bottom surface MLa of the main layer ML. An outer side surface INc1 of the inhibitor IN may be aligned to the side surface MLc of the main layer ML. An inner side surface INc2 of the inhibitor IN may be in contact with the side surface SLc of the seed layer SL.

The penetration spacer TS may be provided on the side surfaces SLc and MLc of the penetration conductive pattern TC. The penetration spacer TS may cover an inner side surface of the penetration hole TH. The penetration spacer TS may be vertically extended in a region between the penetration conductive pattern TC and the interlayer insulating layers 110, 120, and 130. The penetration spacer TS may separate the penetration conductive pattern TC from the interlayer insulating layers 110, 120, and 130.

The penetration spacer TS may be spaced apart from the side surface SLc of the seed layer SL by the inhibitor IN. The penetration spacer TS may be in contact with the side surface MLc of the main layer ML and the outer side surface INc1 of the inhibitor IN. The penetration spacer TS may not cover at least a portion of the bottom surface of the penetration conductive pattern TC (e.g., the bottom surface SLa of the seed layer SL) and at least a portion of the bottom surface INa of the inhibitor IN. In some implementations, the penetration spacer TS may be formed of or include silicon nitride.

The lower contact pattern LCP may be interposed between the back-side metal layer BSM and the penetration conductive pattern TC. The lower contact pattern LCP may be enclosed by the device isolation layer ST. The lower contact pattern LCP may be provided below the penetration conductive pattern TC to electrically connect the penetration conductive pattern TC to the back-side metal layer BSM. A width of the lower contact pattern LCP in the first or second direction D1 or D2 may increase in a downward direction, but the concept is not limited to this example. As an example, the lower contact pattern LCP may have a trapezoidal shape that has a greater width at its bottom surface than its top surface, when viewed in a sectional view.

The lower contact pattern LCP may be in contact with the bottom surface SLa of the seed layer SL, as shown in FIG. 5. The lower contact pattern LCP may cover a bottom surface of the seed layer SL. The lower contact pattern LCP may be in contact with the bottom surface INa of the inhibitor IN. A top surface of the lower contact pattern LCP may be located at a level that is substantially equal to or different from a top surface of the device isolation layer ST.

The lower contact pattern LCP may extend into the penetration hole TH, as shown in FIG. 6. In a fabrication method to be described below, a region below the penetration conductive pattern TC may be etched when the lower contact pattern LCP is formed, and a lower portion of the penetration conductive pattern TC may also be etched during this step. Accordingly, the penetration conductive pattern TC may be recessed in a downward direction. In some implementations, the seed layer SL of the penetration conductive pattern TC and the inhibitor IN may be etched together, and the lower contact pattern LCP may be in contact with the main layer ML of the penetration conductive pattern TC. The top surface of the lower contact pattern LCP may be located at a level higher than the top surface of the device isolation layer ST.

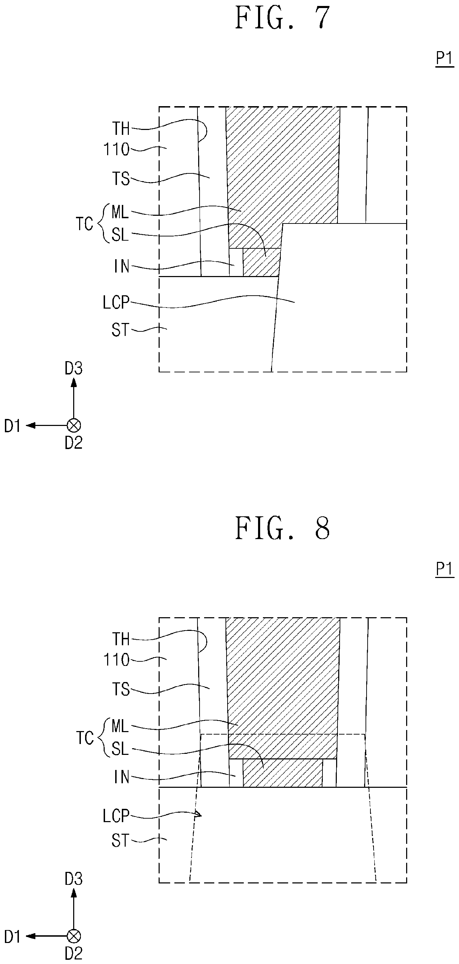

The lower contact pattern LCP may be vertically overlapped with a portion of the penetration conductive pattern TC and may be horizontally offset from the penetration conductive pattern TC, as shown in FIGS. 7 and 8. The seed layer SL may not be left in the region overlapped with the lower contact pattern LCP, because it is etched during the formation of the lower contact pattern LCP. In the region where is not vertically overlapped with the lower contact pattern LCP, the seed layer SL may not be etched and may remain, and the bottom surface SLa of the seed layer SL may be in contact with the device isolation layer ST. However, when there is a difference between the offset direction and the sectional direction, the entirety of the seed layer SL may appear to be remaining, as shown in FIG. 8.

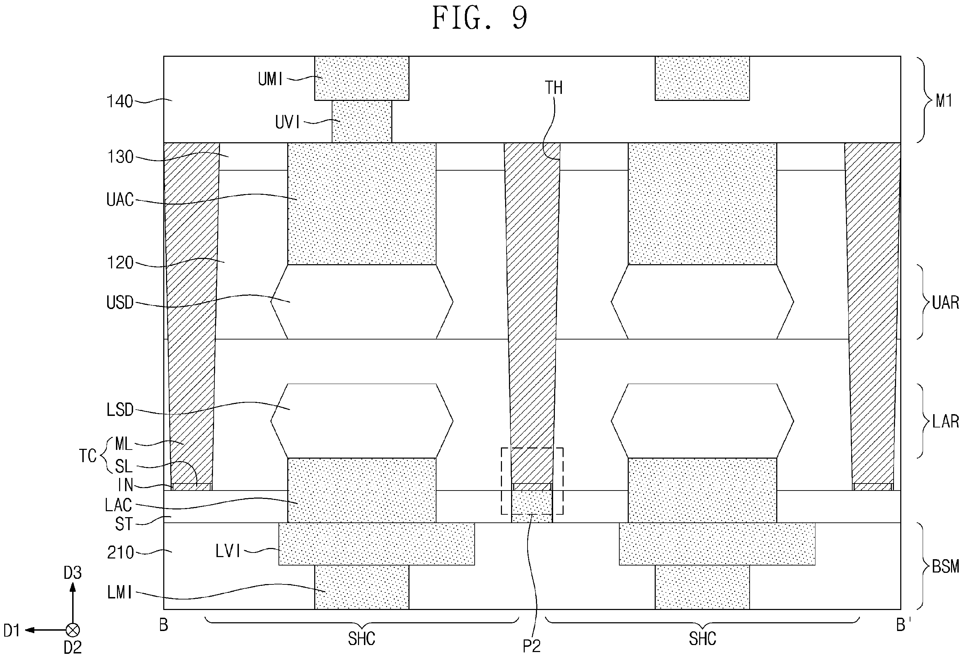

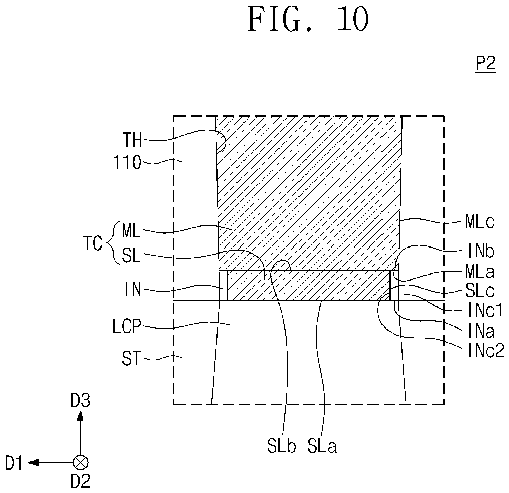

FIG. 9 is an example sectional view taken along the line B-B' of FIG. 3. FIG. 10 is an example enlarged view corresponding to a portion `P2' of FIG. 9. Hereinafter, the penetration conductive pattern will be described with reference to FIGS. 9 and 10.

Referring to FIGS. 9 and 10, the penetration spacer TS may not be provided on the inner side surface of the penetration hole TH. The side surface MLc of the main layer ML and the outer side surface INc1 of the inhibitor IN may be aligned to each other, on the inner side surface of the penetration hole TH. The penetration conductive pattern TC and the inhibitor IN may be in contact with the interlayer insulating layers 110, 120, and 130. As an example, the main layer ML may be in contact with the interlayer insulating layers 110, 120, and 130, and the seed layer SL may be spaced apart from the interlayer insulating layers 110, 120, and 130 with the inhibitor IN interposed therebetween.

The lower contact pattern LCP of FIG. 10 is illustrated to have a structure similar to that in FIG. 5, but the penetration conductive pattern TC and the lower contact pattern LCP may be provided to have substantially the same or similar structural features as those in FIGS. 6 to 8.

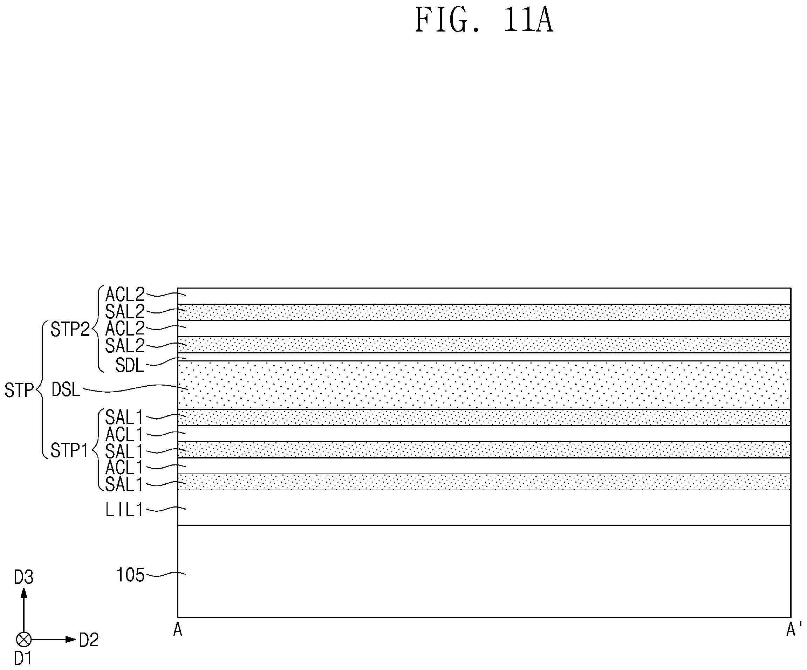

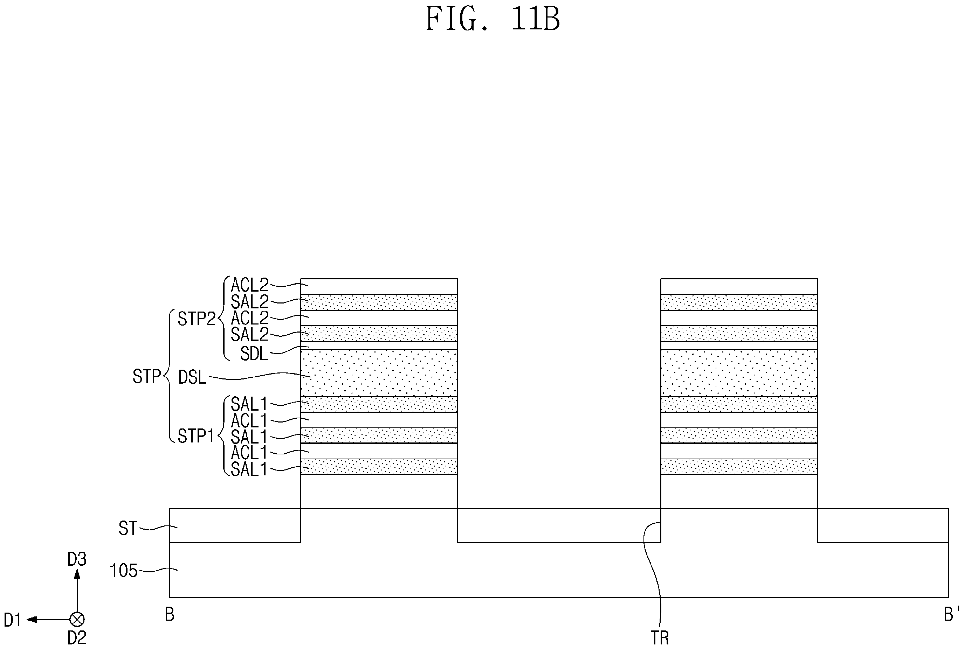

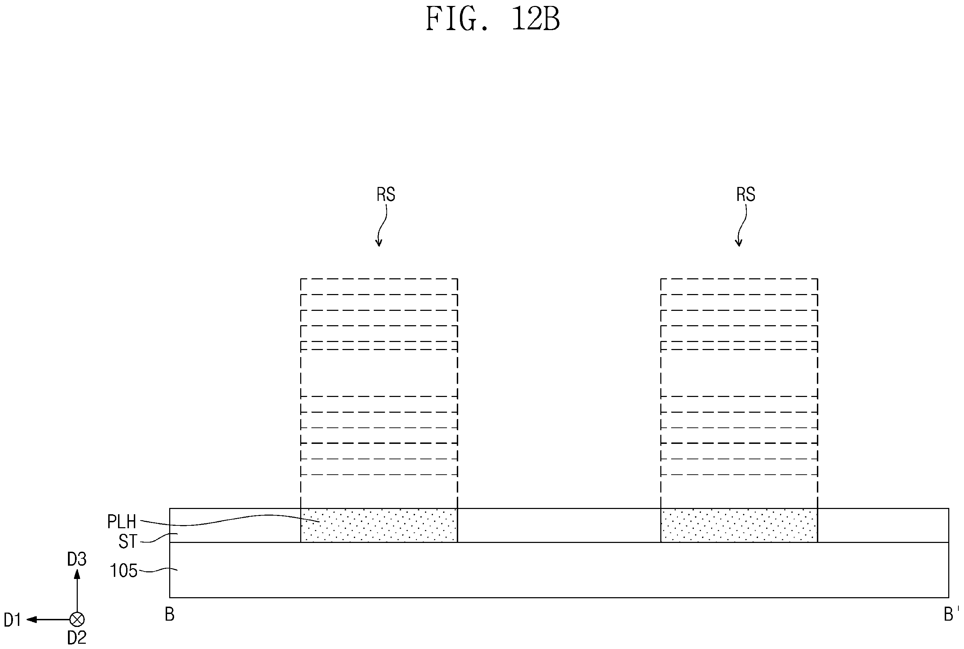

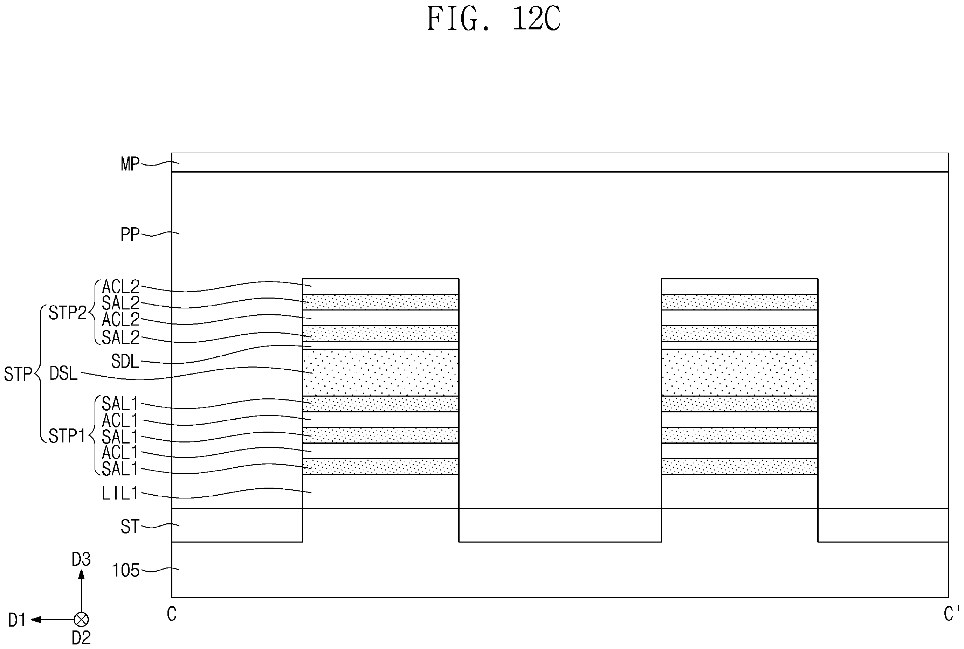

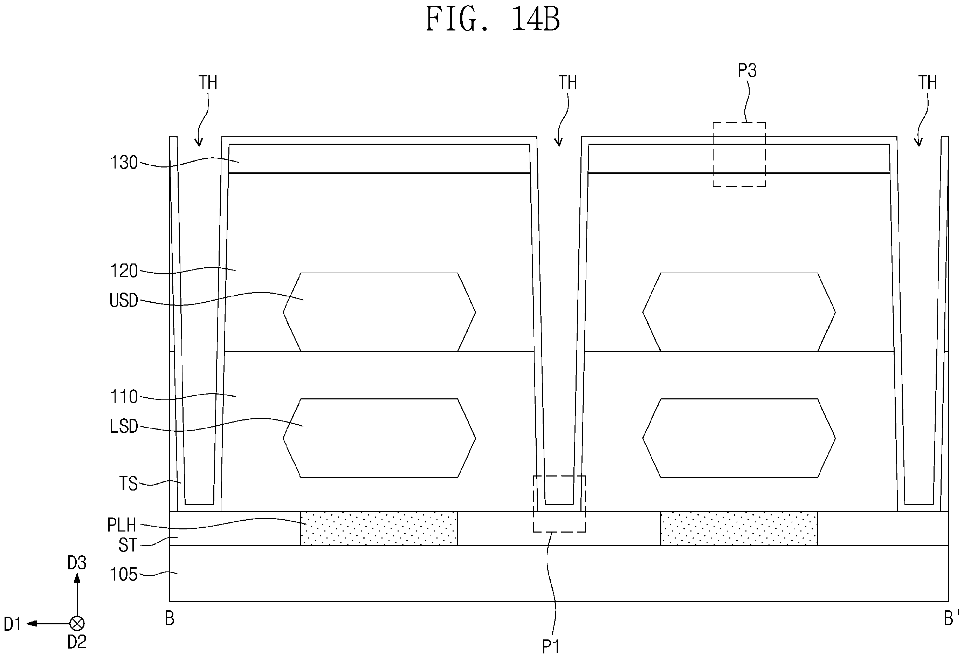

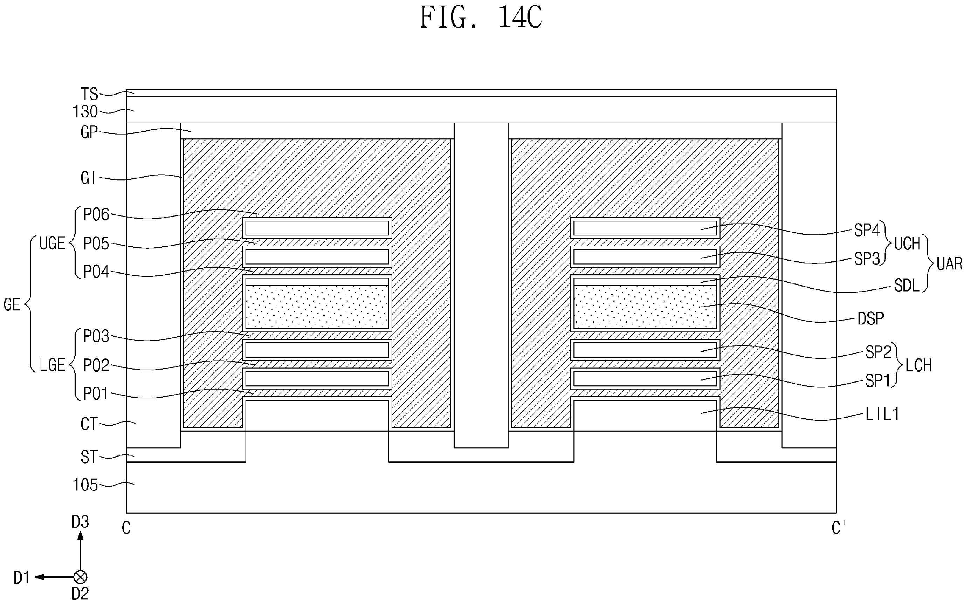

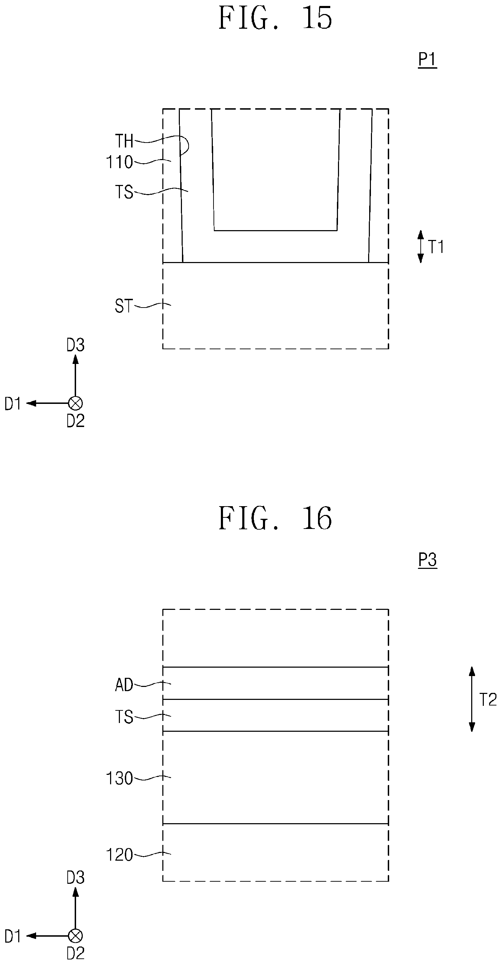

FIGS. 11A to 20 are diagrams illustrating an example of a method of fabricating a three-dimensional semiconductor device. More specifically, FIGS. 11A, 12A, 13A, and 14A are sectional views taken along the line A-A' of FIG. 3. FIGS. 11B, 12B, 13B, 14B, 17, and 19 are sectional views taken along the line B-B' of FIG. 3. FIGS. 12C and 14C are sectional views taken along the line C-C' of FIG. 3. FIGS. 15, 18, and 20 are enlarged sectional views corresponding to portions P1 of FIGS. 14B, 17, and 19. FIG. 16 is an enlarged sectional view corresponding to a portion P3 of FIG. 14B.

Hereinafter, a method of fabricating the semiconductor device of FIGS. 3 to 4C will be described in more detail with reference to FIGS. 11A to 20. For concise description, a previously described element may be identified by the same reference number without repeating an overlapping description thereof.

Referring to FIGS. 11A and 11B, a semiconductor substrate 105 may be provided. The semiconductor substrate 105 may be formed of or include at least one of silicon (Si), germanium (Ge), or silicon-germanium (SiGe). For example, the semiconductor substrate 105 may be a single crystalline silicon wafer.

A first lower insulating layer LIL1 may be formed on the semiconductor substrate 105. The first lower insulating layer LIL1 may be formed of or include at least one of silicon-based insulating materials (e.g., silicon oxide) and/or semiconductor materials (e.g., Si or SiGe).

First sacrificial layers SAL1 and first active layers ACL1 may be alternatively formed on the first lower insulating layer LIL1. The first sacrificial layers SAL1 and the first active layers ACL1 may be formed of or include at least one of silicon (Si), germanium (Ge), or silicon germanium (SiGe) and may be formed of different materials from each other. For example, the first sacrificial layers SAL1 may be formed of or include silicon germanium (SiGe), and the first active layers ACL1 may be formed of or include silicon (Si). A concentration of germanium (Ge) in each of the first sacrificial layers SAL1 may range from 10 at% to 30 at%.

A separation layer DSL may be formed on the uppermost one of the first sacrificial layers SAL1. In some implementations, a thickness of the separation layer DSL may be larger than a thickness of the first sacrificial layer SAL1. The separation layer DSL may be formed of or include silicon (Si) or silicon germanium (SiGe). In the case where the separation layer DSL includes silicon germanium (SiGe), a germanium concentration of the separation layer DSL may be higher than a germanium concentration of the first sacrificial layer SAL1. For example, the germanium concentration of the separation layer DSL may range from 40 at% to 90 at%.

The seed layer SDL may be formed on the separation layer DSL. The seed layer SDL may be formed of or include the same the material as the first active layer ACL1. Second sacrificial layers SAL2 and second active layers ACL2 may be alternatively stacked on the seed layer SDL. Each of the second sacrificial layers SAL2 may be formed of or include the same material as the first sacrificial layer SAL1, and each of the second active layers ACL2 may be formed of or include the same material as the first active layer ACL1. The separation layer DSL may be interposed between the first sacrificial layer SAL1 and the seed layer SDL.

A stacking pattern STP may be formed by patterning the first and second sacrificial layers SAL1 and SAL2, the first and second active layers ACL1 and ACL2, and the separation layer DSL which are stacked. The formation of the stacking pattern STP may include forming a hard mask pattern on the uppermost one of the second active layers ACL2, and etching the layers SAL1, SAL2, ACL1, ACL2, SDL, and DSL, which are stacked on the semiconductor substrate 105, using the hard mask pattern as an etch mask. During the formation of the stacking pattern STP, an upper portion of the semiconductor substrate 105 may be patterned to form a trench TR defining the single height cell SHC. The stacking pattern STP may be a bar- or line-shaped pattern that extends in the second direction D2.

The stacking pattern STP may include a lower stacking pattern STP1 on the first lower insulating layer LIL1, an upper stacking pattern STP2 on the lower stacking pattern STP1, and the separation layer DSL between the lower and upper stacking patterns STP1 and STP2. The lower stacking pattern STP1 may include the first sacrificial layers SAL1 and the first active layers ACL1 which are alternately stacked. The upper stacking pattern STP2 may include the seed layer SDL and the second sacrificial and active layers SAL2 and ACL2, which are alternatingly stacked on the seed layer SDL. The device isolation layer ST may be formed on the semiconductor substrate 105 to fill the trench TR.

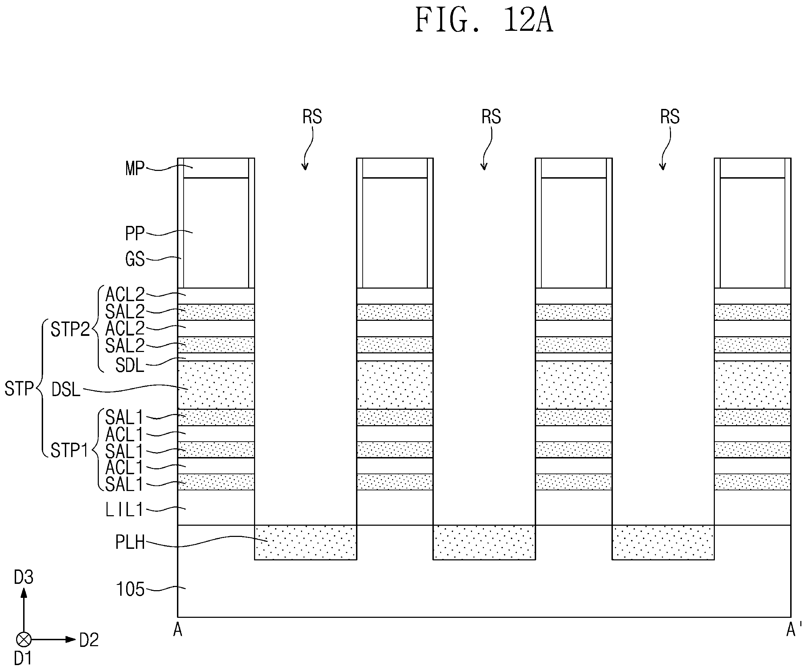

Referring to FIGS. 12A to 12C, a plurality of sacrificial patterns PP may be formed to cross the stacking pattern STP. Each of the sacrificial patterns PP may be formed to have a line shape extended in the first direction D1. In detail, the formation of the sacrificial pattern PP may include forming a sacrificial layer on the semiconductor substrate 105, forming a hard mask pattern MP on the sacrificial layer, and patterning the sacrificial layer using the hard mask pattern MP as an etch mask. The sacrificial layer may be formed of or include amorphous silicon and/or polysilicon.

A pair of the gate spacers GS may be formed on opposite side surfaces of the sacrificial pattern PP, respectively. In detail, a spacer layer may be conformally formed on the semiconductor substrate 105. The spacer layer may cover the sacrificial pattern PP and the hard mask pattern MP. For example, the spacer layer may be formed of or include at least one of SiCN, SiCON, or SiN. The gate spacers GS may be formed by anisotropically etching the spacer layer.

An etching process may be performed on the stacking pattern STP using the gate spacers GS and the hard mask pattern MP as an etch mask. As a result of the etching process, a recess RS may be formed between adjacent ones of the sacrificial patterns PP. Due to the recess RS, the stacking pattern STP may be formed in a vertical bar shape.

Sacrificial contact patterns PLH may be formed in the semiconductor substrate 105 exposed through the recess RS. The sacrificial contact patterns PLH may be formed in the form of a contact plug. The sacrificial contact patterns PLH may be arranged in the second direction D2. The sacrificial contact patterns PLH may be formed of or include a material (e.g., silicon-germanium (SiGe)) having an etch selectivity with respect to the semiconductor substrate 105. The sacrificial contact patterns PLH may be formed by an epitaxial growth process. The recess RS may be formed to expose the sacrificial contact pattern PLH. That is, the recess RS may be overlapped with the sacrificial contact pattern PLH.

In the case where the separation layer DSL includes silicon germanium (SiGe), the separation layer DSL may be replaced with a silicon-based insulating material. For example, the separation layer DSL, which is exposed through the recess RS, may be selectively removed to form an empty region, and then, a silicon-based insulating material (e.g., silicon nitride) may be formed to fill the empty region.

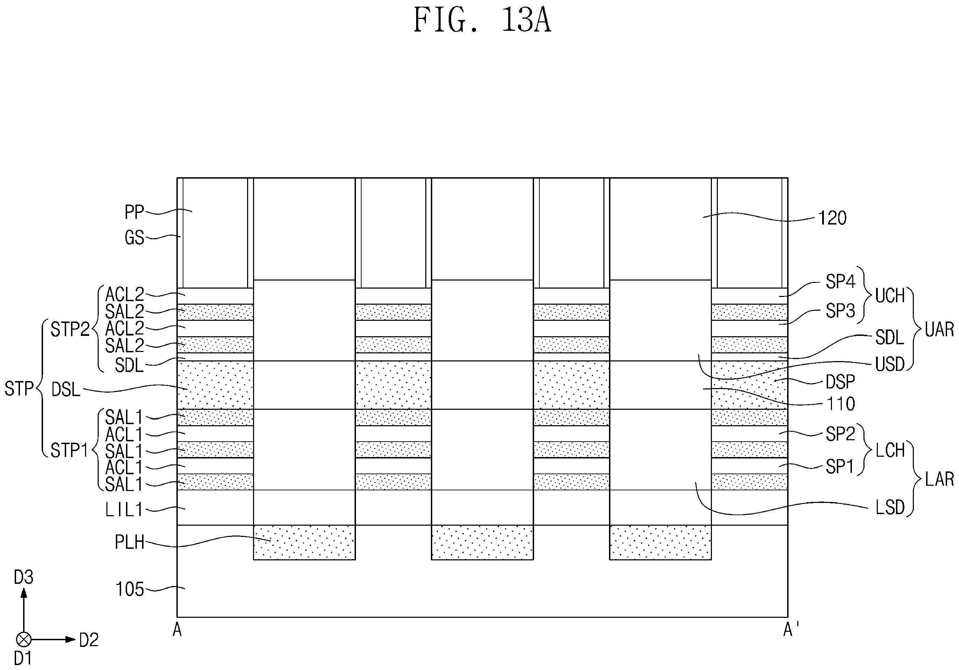

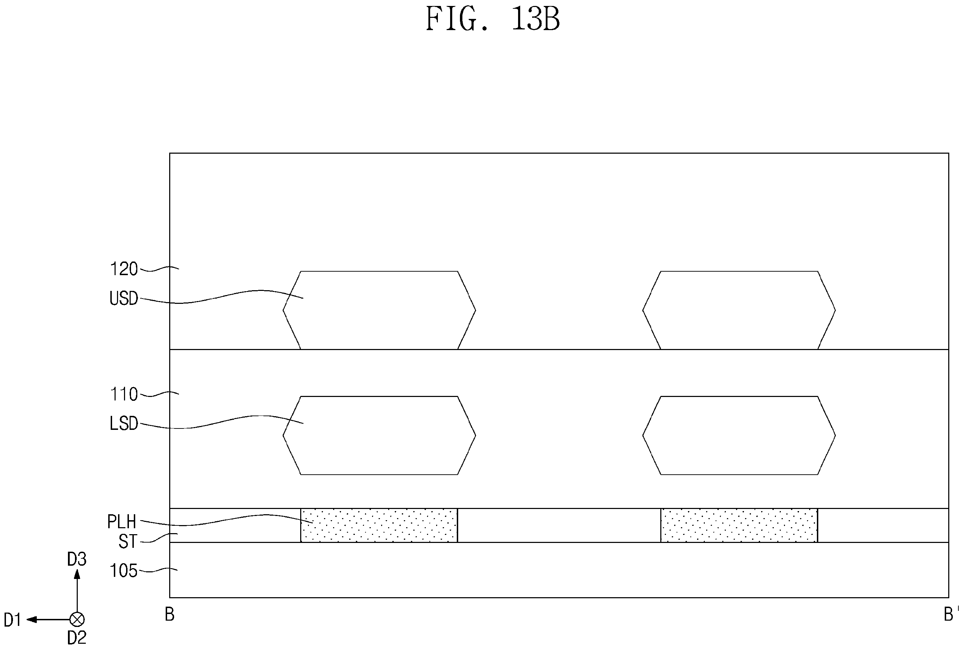

Referring to FIGS. 13A and 13B, the lower source/drain pattern LSD may be formed in the recess RS. In detail, the lower source/drain pattern LSD may be formed by performing a first SEG process using a side surface of the lower stacking pattern STP1, which is exposed through the recess RS, as a seed layer. The lower source/drain pattern LSD may be grown using the first active layers ACL1, which are exposed through the recess RS, as a seed layer. As an example, the first SEG process may include a chemical vapor deposition (CVD) process or a molecular beam epitaxy (MBE) process.

As an example, impurities may be injected into the lower source/drain pattern LSD in an in-situ manner during the first SEG process. As another example, impurities may be injected into the lower source/drain pattern LSD, after the formation of the lower source/drain pattern LSD. The lower source/drain pattern LSD may be doped to have a first conductivity type (e.g., an n-type).

The first active layers ACL1, which are interposed between the paired lower source/drain patterns LSD, may constitute the lower channel pattern LCH. That is, the first and second semiconductor patterns SP1 and SP2 of the lower channel pattern LCH may be formed from the first active layers ACL1. The lower channel patterns LCH and the lower source/drain patterns LSD may constitute the lower active region LAR serving as the bottom tier of the three-dimensional device.

The lower source/drain pattern LSD may be formed to fully fill a space between a pair of the lower channel patterns LCH. That is, the first SEG process may be performed for a sufficient time until the lower source/drain pattern LSD is grown to fill a space between the pair of lower channel patterns LCH and connect the pair of lower channel patterns LCH to each other.

The first interlayer insulating layer 110 may be formed to cover the lower source/drain pattern LSD. In some implementations, an etch stop layer may be additionally formed to conformally cover the lower source/drain pattern LSD, before the formation of the first interlayer insulating layer 110. In some implementations, a portion of the first interlayer insulating layer 110 may be formed below the lower source/drain pattern LSD before the formation of the lower source/drain pattern LSD, and another portion of the first interlayer insulating layer 110 may be further formed after the formation of the lower source/drain pattern LSD.

In the recess RS, the first interlayer insulating layer 110 may cover a side surface of the upper stacking pattern STP2. Next, an upper portion of the first interlayer insulating layer 110 may be removed to expose the side surface of the upper stacking pattern STP2 in the recess RS again. The upper source/drain pattern USD may be formed on the exposed side surface of the upper stacking pattern STP2. In detail, the upper source/drain pattern USD may be formed by a second SEG process, in which the side surface of the upper stacking pattern STP2 exposed by the recess RS is used as a seed layer. The upper source/drain pattern USD may be grown using the second active layers ACL2, which is exposed by the recess RS, as a seed layer. The upper source/drain pattern USD may be doped to have a second conductivity type (e.g., p type) that is different from the first conductivity type.

The second active layers ACL2, which are interposed between a pair of upper source/drain patterns USD, may serve as the upper channel pattern UCH. That is, the third and fourth semiconductor patterns SP3 and SP4 of the upper channel pattern UCH may be formed from the second active layers ACL2. The upper channel patterns UCH and the upper source/drain patterns USD may constitute the upper active region UAR, which is a top tier of the three-dimensional device. The second SEG process may also be performed for a sufficient time, such that a space between the pair of upper channel patterns UCH is fully filled with the upper source/drain pattern USD.

The second interlayer insulating layer 120 may be formed to cover the upper source/drain pattern USD. In some implementations, an etch stop layer may be further formed to conformally cover the upper source/drain pattern USD, before the formation of the second interlayer insulating layer 120.

Thereafter, the second interlayer insulating layer 120 may be planarized to expose a top surface of the sacrificial pattern PP. The planarization of the second interlayer insulating layer 120 may be performed using an etch-back process or a chemical mechanical polishing (CMP) process. All of the hard mask pattern MP on the sacrificial pattern PP may be removed during the planarization process. As a result, the top surface of the second interlayer insulating layer 120 may be coplanar with the top surface of the sacrificial pattern PP and the top surfaces of the gate spacers GS.

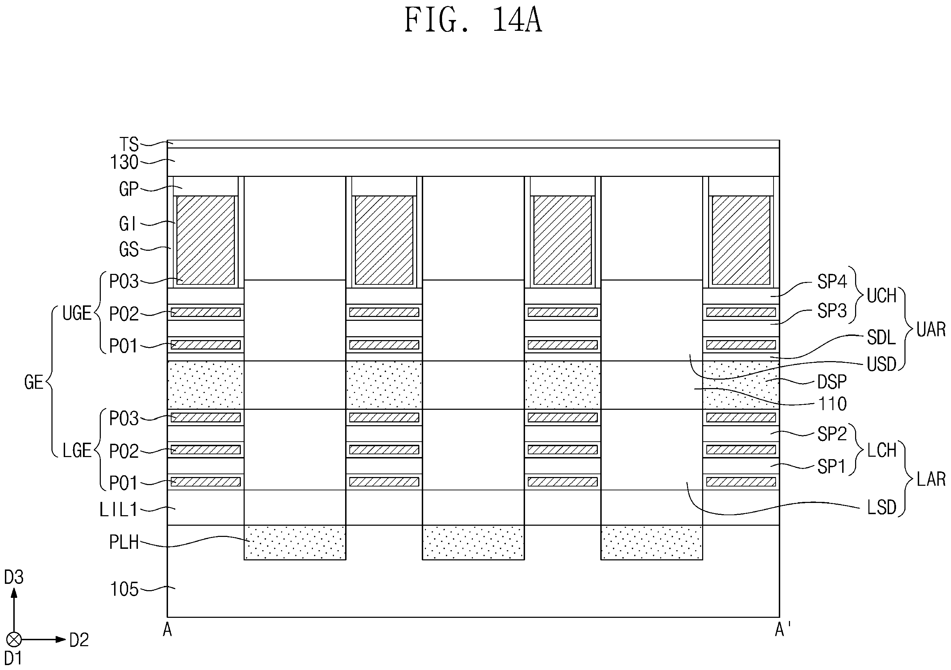

Referring to FIGS. 14A to 16, the exposed sacrificial pattern PP may be selectively removed. The removal of the sacrificial pattern PP may include a wet etching process using etching solution capable of selectively etching polysilicon. As a result of the removal of the sacrificial pattern PP, the first and second sacrificial layers SAL1 and SAL2 may be exposed.

An etching process, which is chosen to selectively etch the first and second sacrificial layers SAL1 and SAL2, may be performed to leave the first to fourth semiconductor patterns SP1 to SP4 and the dummy channel pattern DSP and to remove only the first and second sacrificial layers SAL1 and SAL2. The etching process may be chosen to have a high etch rate to silicon germanium. For example, the etching process may be chosen to have a high etch rate to a silicon germanium layer whose germanium concentration is higher than 10 at%.

The gate insulating layer GI may be conformally formed in an empty space, which is formed by removing the sacrificial pattern PP and the first and second sacrificial layers SAL1 and SAL2. The gate electrode GE may be formed on the gate insulating layer GI. The formation of the gate electrode GE may include forming the first to fifth inner electrodes PO1 to PO5 between the first to fourth semiconductor patterns SP1 to SP4 and forming the outer electrode PO6 in a region, which is formed by removing the sacrificial pattern PP. The cutting pattern CT may be additionally formed in the region formed by removing the sacrificial pattern PP, before or after the formation of the gate electrode GE.

The gate electrode GE may be recessed to have a reduced height. The gate capping pattern GP may be formed on the recessed gate electrode GE. A planarization process may be performed on the gate capping pattern GP such that a top surface of the gate capping pattern GP is coplanar with the top surface of the second interlayer insulating layer 120. The third interlayer insulating layer 130 may be formed to cover the gate electrode GE and the second interlayer insulating layer 120.

The penetration hole TH may be formed to penetrate the interlayer insulating layers 110, 120, and 130. The penetration hole TH may be formed through an anisotropic etching process. The etching process may be performed until the device isolation layer ST is exposed through the penetration hole TH. A width of the penetration hole TH may decrease as a height is lowered.

The penetration spacer TS may be formed to cover an inner surface of the penetration hole TH and the third interlayer insulating layer 130. The penetration spacer TS may be formed on the entire top surface of the semiconductor substrate 105. As an example, the penetration spacer TS may conformally cover the entire top surface of the semiconductor substrate 105. The penetration spacer TS may cover the top surface of the device isolation layer ST, which is exposed through an inner bottom surface of the penetration hole TH.

In some implementations, an auxiliary deposition layer AD may be formed on the top surface of the third interlayer insulating layer 130 to cover the penetration spacer TS (e.g., see FIG. 16). The auxiliary deposition layer AD may not be formed on the inner bottom surface of the penetration hole TH. The penetration spacer TS may have a first thickness T1 on the inner bottom surface of the penetration hole TH (e.g., see FIG. 15). A sum of thicknesses of the penetration spacer TS and the auxiliary deposition layer AD on the third interlayer insulating layer 130 may be a second thickness T2 (e.g., see FIG. 16). The second thickness T2 may be larger than the first thickness T1. In some implementations, the auxiliary deposition layer AD may be formed through a physical vapor deposition (PVD) process. Due to the poor step coverage property of the PVD process, the auxiliary deposition layer AD may not be deposited on the inner bottom surface of the penetration hole TH. The auxiliary deposition layer AD may be formed of or include the same material as the penetration spacer TS.

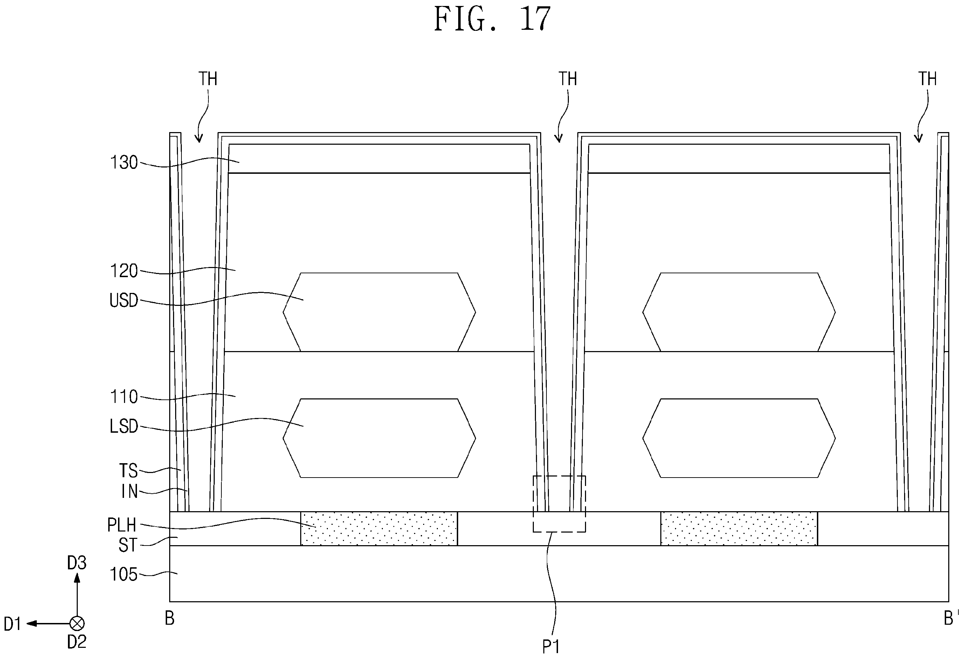

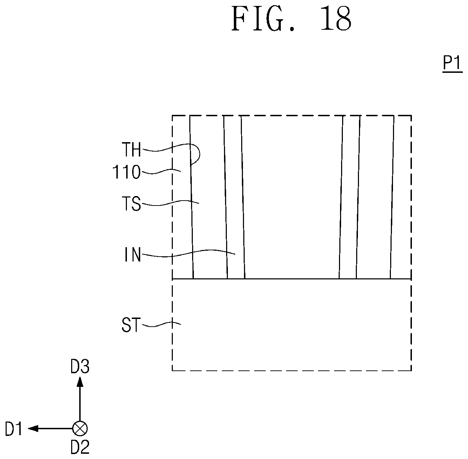

Referring to FIGS. 17 and 18, the penetration spacer TS may be removed from the inner bottom surface of the penetration hole TH. Thus, the top surface of the device isolation layer ST may be re-opened through the inner bottom surface of the penetration hole TH. The removal process may be performed through an anisotropic etching process on the penetration spacer TS, and thus, the penetration spacer TS may be left on the inner side surface of the penetration hole TH. The auxiliary deposition layer AD may protect the penetration spacer TS on the third interlayer insulating layer 130, and thus, the penetration spacer TS may be left on the third interlayer insulating layer 130 even after the etching process.

The inhibitor IN may be formed to cover the penetration spacer TS. The inhibitor IN may be selectively deposited on the surface of the penetration spacer TS. In other words, the inhibitor IN may not be formed on the inner bottom surface of the penetration hole TH. Accordingly, the top surface of the device isolation layer ST may still be exposed through the inner bottom surface of the penetration hole TH, even after the formation of the inhibitor IN. The inhibitor IN may be formed on the inner side surface of the penetration hole TH and the top surface of the third interlayer insulating layer 130.

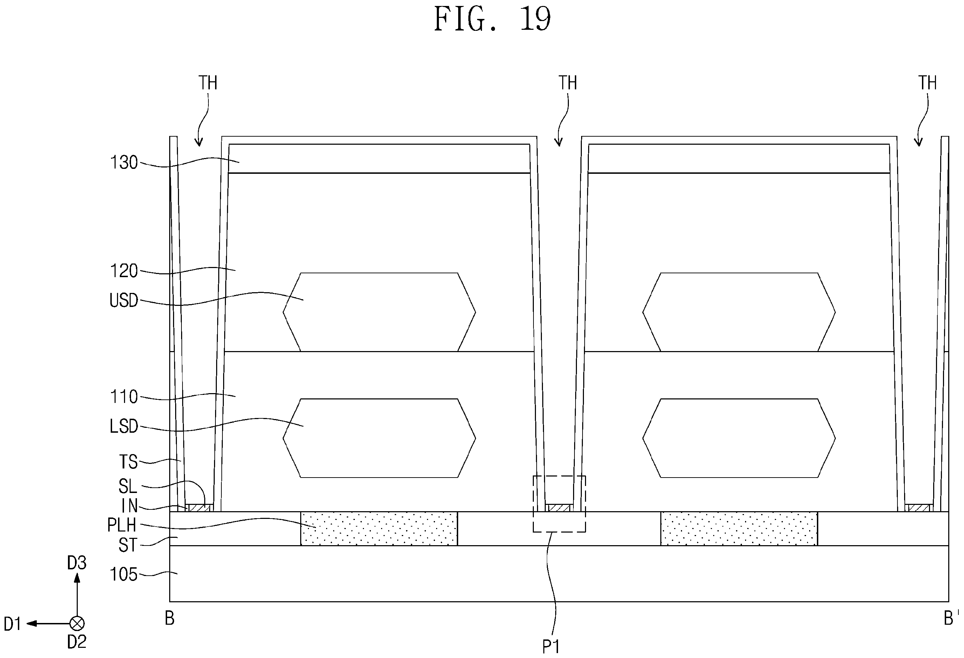

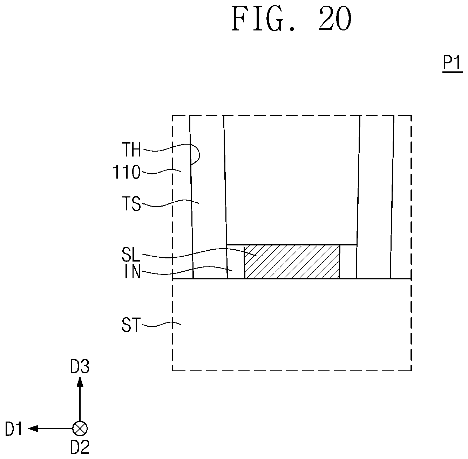

Referring to FIGS. 19 and 20, the seed layer SL may be formed on the inner bottom surface of the penetration hole TH. The seed layer SL may be selectively deposited on the exposed top surface of the device isolation layer ST. More specifically, the seed layer SL may not be directly formed on a surface of the inhibitor IN in the process of forming the seed layer SL. The inhibitor IN may prevent or suppress the seed layer SL from being formed on the penetration spacer TS, and the seed layer SL may not be deposited on the inner side surface of the penetration hole TH and the top surface of the third interlayer insulating layer 130. The seed layer SL may fill a lower portion of the penetration hole TH and cover the exposed top surface of the device isolation layer ST. Although the seed layer SL is not directly formed on the surface of the inhibitor IN, the seed layer SL may be in contact with a lower portion of the inhibitor IN, because the seed layer SL is formed on the device isolation layer ST in the lower portion of the penetration hole TH. The lower portion of the inhibitor IN may enclose the seed layer SL. In some implementations, the seed layer SL may be formed by an atomic layer deposition (ALD) process. The process of forming the seed layer SL may be formed at a first temperature.

Next, a removal process may be performed on the inhibitor IN. The inhibitor IN may be removed by an annealing process. The annealing process may be performed at a second temperature. The second temperature may be higher than the first temperature, at which the seed layer SL is formed. Accordingly, the inhibitor IN may not be removed during the formation of the seed layer SL (i.e., at the first temperature).

The removal process may be performed to remove an upper portion of the inhibitor IN, and the lower portion of the inhibitor IN may be left between the seed layer SL and the penetration spacer TS. The lower portion of the inhibitor IN may be left on the side surface of the seed layer SL and may enclose the seed layer SL. Since the upper portion of the inhibitor IN is removed, the penetration spacer TS may be exposed to the outside.

Referring back to FIGS. 3 to 8, the main layer ML may be formed to fill an upper portion of the penetration hole TH. The main layer ML may be formed by a selective growth process using the seed layer SL as a seed. Accordingly, in the penetration hole TH, the main layer ML may be gradually grown from the seed layer SL toward the top of the penetration hole TH (i.e., in a bottom-up growth manner).

In the growth process, the penetration spacer TS may not be used as the seed. Thus, the main layer ML may be formed to have no seam therein, unlike the conformal deposition process, in which the deposition is performed on the side surface of the penetration hole TH, and in some implementations, the main layer ML may be formed of a single grain or few grain. In this case, the penetration conductive pattern TC may have reduced resistance, which allows for improved electrical characteristics of the three-dimensional semiconductor device, and furthermore, it may be possible to reduce the occurrence of failures in a subsequent process due to the seam.

In addition, the bottom-up growth process may reduce the processing time, compared to the conformal deposition process. As a result, it may be possible to improve productivity in the process of fabricating the three-dimensional semiconductor device.

The upper active contacts UAC may be formed to penetrate the second and third interlayer insulating layers 120 and 130 and may be coupled to the upper source/drain patterns USD, respectively. The upper gate contact UGC may be formed to penetrate the second and third interlayer insulating layers 120 and 130 and may be coupled to the gate electrode GE. The upper active contacts UAC and the upper gate contact UGC may be formed during a process of forming the penetration conductive pattern TC or by another process that is different from the process of forming the penetration conductive pattern TC. The penetration spacer TS may be removed from the top surface of the third interlayer insulating layer 130 and may be left on the inner side surface of the penetration hole TH.

The fourth interlayer insulating layer 140 may be formed on the third interlayer insulating layer 130. The first metal layer M1 including the upper interconnection lines UMI may be formed in the fourth interlayer insulating layer 140. The upper vias UVI may be formed to electrically connect the first metal layer M1 to the gate contacts GC and the upper active contacts UAC. A BEOL layer including the additional metal layers (e.g., M2, M3, M4, and so forth) may be formed on the first metal layer M1.

Thereafter, the semiconductor substrate 105 may be inverted such that a rear surface of the semiconductor substrate 105 is exposed to the outside. The exposed semiconductor substrate 105 may be selectively removed. Accordingly, the sacrificial contact patterns PLH and the first lower insulating layer LIL1 may be exposed.

A second lower insulating layer LIL2 may be formed on the exposed sacrificial contact patterns PLH and the exposed first lower insulating layer LIL1. For example, the second lower insulating layer LIL2 may be formed of or include at least one of silicon-based insulating materials (e.g., silicon oxide, silicon oxynitride, or silicon nitride). In some implementations, the second lower insulating layer LIL2 may be formed of or include the same material as the device isolation layer ST.

The first and second lower insulating layers LIL1 and LIL2 may constitute the substrate 100. The substrate 100 may include the first surface 100a and the second surface 100b. A planarization process may be performed on the second surface 100b of the substrate 100 to expose top surfaces of the sacrificial contact patterns PLH.

The sacrificial contact pattern PLH may be replaced with the lower active contact LAC. In detail, the sacrificial contact pattern PLH may be selectively removed. An etching process may be further performed on a region, which is formed by removing the sacrificial contact pattern PLH, to expose the lower source/drain pattern LSD. The lower active contact LAC may be formed to be coupled to the exposed lower source/drain pattern LSD. The lower active contact LAC may be formed in a self-aligned manner using the sacrificial contact pattern PLH.

The lower gate contact LGC may be formed to penetrate the substrate 100 and may be coupled to the gate electrode GE. The lower contact pattern LCP of FIGS. 5 to 8 may be further formed through the process of forming the lower gate contact LGC or through an additional process. The formation of the lower contact pattern LCP may include etching a portion of the substrate 100, which is vertically overlapped with the penetration conductive pattern TC, and filling the etched region with the lower contact pattern LCP. Here, the lower contact pattern LCP of FIGS. 5 to 8 may be formed in various shapes, depending on the alignment and depth of the etched region.

The lower interlayer insulating layer 210 may be formed on the second surface 100b of the substrate 100. The back-side metal layer BSM may be formed in the lower interlayer insulating layer 210. The back-side metal layer BSM may include the lower interconnection lines LMI. In addition, the lower vias LVI may be formed to electrically connect the back-side metal layer BSM to the lower active contact LAC and the lower gate contact LGC. In some implementations, the lower via LVI may be formed to connect the lower active contact LAC to the lower interconnection lines LMI. Back-side metal layers may be additionally formed on the back-side metal layer BSM. In some implementations, the back-side metal layers may include a power delivery network.

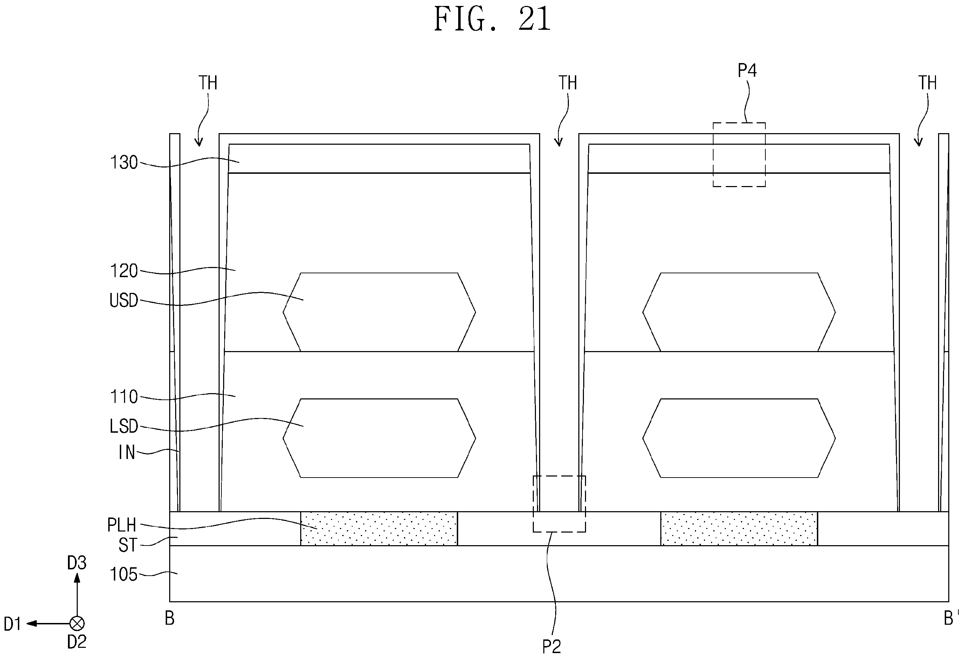

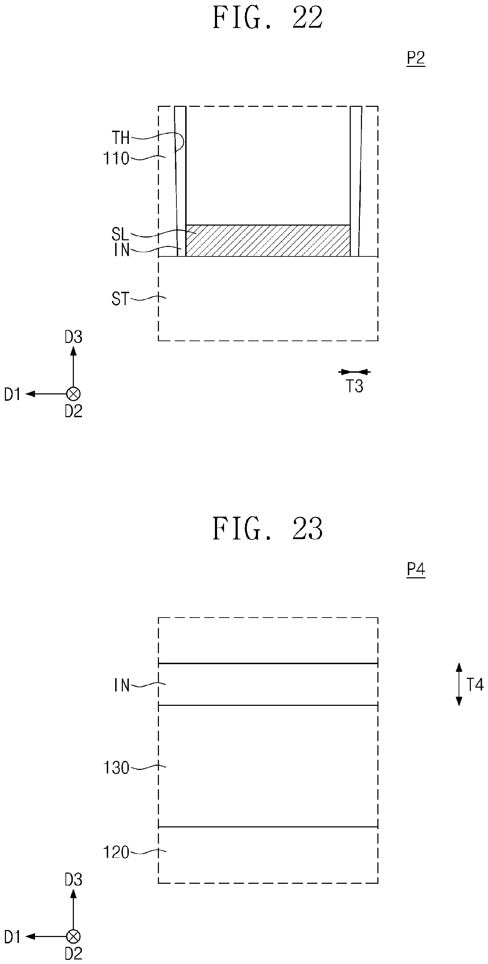

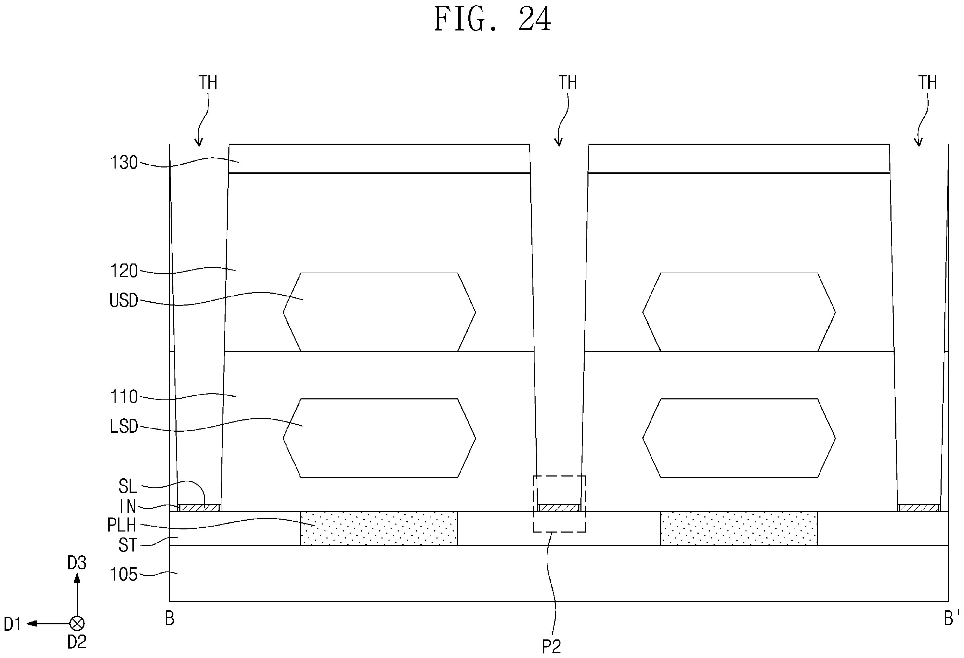

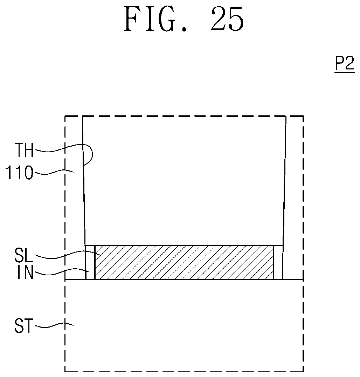

FIGS. 21 to 25 are diagrams illustrating another example of a method of fabricating a three-dimensional semiconductor device. More specifically, FIGS. 21 and 24 are sectional views taken along the line B-B' of FIG. 3. FIGS. 22 and 25 are enlarged sectional views corresponding to portions of P2 of FIGS. 21 and 24. FIG. 23 is an enlarged view corresponding to a portion P4 of FIG. 21.

Hereinafter, a method of fabricating the semiconductor device of FIG. 9 will be described in more detail with reference to FIGS. 21 to 25. For concise description, a previously described element may be identified by the same reference number without repeating an overlapping description thereof.

Referring to FIGS. 21 to 23, the inhibitor IN may be formed after the formation of the penetration hole TH without the formation of the penetration spacer TS, unlike the implementation of FIGS. 14A to 14C. In the case where the inhibitor IN is formed by a method with a poor step coverage property, the inhibitor IN may not be substantially formed in a lower portion of the penetration hole TH. As an example, the inhibitor IN may be formed on the inner side surface of the penetration hole TH and the top surface of the third interlayer insulating layer 130 but may not be formed on the inner bottom surface of the penetration hole TH. Thus, after the formation of the inhibitor IN, the top surface of the device isolation layer ST may be exposed through the inner bottom surface of the penetration hole TH.

The inhibitor IN may have a third thickness T3 on the bottommost portion of the inner side surface of the penetration hole TH and may have a fourth thickness T4 on the top surface of the third interlayer insulating layer 130. Due to the step coverage property of the inhibitor IN, the fourth thickness T4 may be larger than the third thickness T3.

Next, the seed layer SL may be formed on the inner bottom surface of the penetration hole TH. The seed layer SL may be selectively deposited on the exposed top surface of the device isolation layer ST. The seed layer SL may not be deposited on the inner side surface of the penetration hole TH and the top surface of the third interlayer insulating layer 130.

Referring to FIGS. 24 and 25, a removal process may be performed on the inhibitor IN. The removal process may be performed to remove an upper portion of the inhibitor IN, and the lower portion of the inhibitor IN may be left between the seed layer SL and the penetration spacer TS.

Thereafter, the three-dimensional semiconductor device of FIG. 9 may be fabricated through the afore-described method.

In some implementations, a penetration conductive pattern may be formed to have a seam-free structure and may be formed of a single grain or few grain. Accordingly, an electric resistance of the penetration conductive pattern may be lowered, and this may make it possible to improve the electrical characteristics of the three-dimensional semiconductor device. Furthermore, it may be possible to reduce failures, which may occur in a subsequent process due to the seam.

In addition, the penetration conductive pattern may be formed through a bottom-up growth process, which enables a reduction in processing time compared to the conformal deposition process. As a result, it may be possible to improve productivity in the process of fabricating the three-dimensional semiconductor device.

Example embodiments are set out in the following clauses:
Clause 1. A three-dimensional semiconductor device, comprising:
   a back-side metal layer;
   a lower active region on the back-side metal layer, the lower active region including a lower channel pattern and a lower source drain pattern connected with the lower channel pattern;
   an upper active region on the lower active region, the upper active region including an upper channel pattern and an upper source drain pattern connected with the upper channel pattern;
   an interlayer insulating layer that encloses the lower source drain pattern and the upper source drain pattern;
   a penetration conductive pattern that extends through the interlayer insulating layer in a vertical direction; and
   an inhibitor that covers a side surface of a lower portion of the penetration conductive pattern, wherein the inhibitor includes a carbon atom.
Clause 2. The three-dimensional semiconductor device of clause 1, wherein a bottom surface of the inhibitor is coplanar with a bottom surface of the penetration conductive pattern.
Clause 3. The three-dimensional semiconductor device of clause 1 or clause 2, comprising a device isolation layer between the back-side metal layer and the penetration conductive pattern,
   wherein the penetration conductive pattern is in contact with the device isolation layer.
Clause 4. The three-dimensional semiconductor device of any preceding clause, comprising a lower contact pattern between the back-side metal layer and the penetration conductive pattern,
   wherein the penetration conductive pattern is in contact with the lower contact pattern.
Clause 5. The three-dimensional semiconductor device of any preceding clause, comprising a penetration spacer that extends between the penetration conductive pattern and the interlayer insulating layer.
Clause 6. The three-dimensional semiconductor device of clause 5, wherein the penetration spacer separates the penetration conductive pattern from the interlayer insulating layer.
Clause 7. The three-dimensional semiconductor device of clause 5 or clause 6, wherein the inhibitor is disposed between the lower portion of the penetration conductive pattern and the penetration spacer.
Clause 8. The three-dimensional semiconductor device of any of clauses 1-4, wherein a side surface of the penetration conductive pattern is in contact with the interlayer insulating layer.
Clause 9. The three-dimensional semiconductor device of any of clauses 1-4 or clause 8, wherein a side surface of the inhibitor is in contact with the interlayer insulating layer.
Clause 10. The three-dimensional semiconductor device of any preceding clause, wherein the penetration conductive pattern includes at least one of Mo, Ru, Cu, Al, or W.
Clause 11. The three-dimensional semiconductor device of any preceding clause, wherein a side surface of the inhibitor is aligned to a side surface of an upper portion of the penetration conductive pattern.
Clause 12. The three-dimensional semiconductor device of any preceding clause, wherein the inhibitor does not cover at least a portion of a bottom surface of the penetration conductive pattern.
Clause 13. A three-dimensional semiconductor device, comprising:
   a back-side metal layer;
   a lower active region on the back-side metal layer, the lower active region including a lower channel pattern and a lower source drain pattern connected with the lower channel pattern;
   an upper active region on the lower active region, the upper active region including an upper channel pattern and an upper source drain pattern connected with the upper channel pattern;
   an interlayer insulating layer that encloses the lower and upper source drain patterns; and
   a penetration conductive pattern that extends through the interlayer insulating layer in a vertical direction,
   wherein the penetration conductive pattern includes a seed layer and a main layer, the main layer being on the seed layer, and
   wherein a width of a bottom surface of the main layer is larger than a width of a top surface of the seed layer.
Clause 14. The three-dimensional semiconductor device of clause 13, wherein the seed layer and the main layer include different metallic materials.
Clause 15. The three-dimensional semiconductor device of clause 13, wherein the seed layer and the main layer include a same metallic material.
Clause 16. The three-dimensional semiconductor device of any of clauses 13-15, comprising a device isolation layer between the back-side metal layer and the penetration conductive pattern,
   wherein the seed layer is in contact with the device isolation layer.
Clause 17. The three-dimensional semiconductor device of any of clauses 13-16, comprising a penetration spacer on a side surface of the penetration conductive pattern,
   wherein the penetration spacer is spaced apart from a side surface of the seed layer and is in contact with a side surface of the main layer.
Clause 18. The three-dimensional semiconductor device of any of clauses 13-16, comprising an inhibitor that covers a side surface of the seed layer,
   wherein a side surface of the inhibitor is aligned to a side surface of the main layer.
Clause 19. The three-dimensional semiconductor device of clause 18, wherein the main layer covers a top surface of the inhibitor.
Clause 20. The three-dimensional semiconductor device of any of clauses 18-19, wherein the inhibitor includes a carbon atom.
Clause 21. A three-dimensional semiconductor device, comprising:
   a metal layer;
   an interlayer insulating layer on the metal layer;
   a penetration conductive pattern that extends through the interlayer insulating layer in a vertical direction, the penetration conductive pattern comprising a seed layer and a main layer, the main layer being on the seed layer; and
   an inhibitor that covers a side surface of the seed layer,
   wherein the penetration conductive pattern is electrically connected with the metal layer, and
   wherein a side surface of the inhibitor is aligned to a side surface of the main layer.
Clause 22. The three-dimensional semiconductor device of clause 21, wherein the inhibitor includes a carbon atom.
Clause 23. The three-dimensional semiconductor device of clause 21 or clause 22, wherein a width of a bottom surface of the main layer is larger than a width of a top surface of the seed layer.
Clause 24. The three-dimensional semiconductor device of any of clauses 21-23, comprising a device isolation layer between the metal layer and the penetration conductive pattern,
   wherein the seed layer is in contact with the device isolation layer.
Clause 25. A method of fabricating a three-dimensional semiconductor device, comprising:
   forming a penetration hole that extends through an interlayer insulating layer, the interlayer insulating layer being on a device isolation layer;
   forming an inhibitor on an inner side surface of the penetration hole, the inhibitor exposing a top surface of the device isolation layer to the penetration hole;
   forming a seed layer that covers the exposed top surface of the device isolation layer;
   removing an upper portion of the inhibitor; and
   growing a main layer using the seed layer as a seed to fill the penetration hole.
Clause 26. The method of clause 25, wherein the growing of the main layer includes gradually growing, in the penetration hole, the main layer from the seed layer toward an uppermost portion of the penetration hole.
Clause 27. The method of clause 25 or clause 26, wherein the forming of the inhibitor includes:
   forming a penetration spacer that covers an inner surface of the penetration hole;
   removing the penetration spacer from an inner bottom surface of the penetration hole to expose the device isolation layer; and
   depositing the inhibitor on the inner side surface of the penetration hole to cover the penetration spacer,
   wherein the inhibitor is selectively deposited on the inner side surface of the penetration hole.
Clause 28. The method of clause 27, wherein the forming of the penetration spacer comprises:
   forming the penetration spacer on a top surface of the interlayer insulating layer; and
   forming an auxiliary deposition layer on the penetration spacer.
Clause 29. The method of any of clauses 25-28, wherein the removing of the upper portion of the inhibitor is performed to leave a lower portion of the inhibitor on a side surface of the seed layer.
Clause 30. The method of any of clauses 25-29, wherein the forming of the seed layer is performed at a first temperature,
   wherein the removing of the inhibitor is performed at a second temperature, and
   wherein the second temperature is higher than the first temperature.

While this specification contains many specific implementation details, these should not be construed as limitations on the scope of what may be claimed, but rather as descriptions of features that may be specific to particular implementations of particular inventions. Certain features that are described in this specification in the context of separate implementations can also be implemented in combination in a single implementation. Conversely, various features that are described in the context of a single implementation can also be implemented in multiple implementations separately or in any suitable subcombination. Moreover, although features may be described above as acting in certain combinations and even initially be claimed as such, one or more features from a claimed combination can in some cases be excised from the combination, and the claimed combination may be directed to a subcombination or variation of a subcombination.

While example implementations of the concept described herein have been particularly shown and described, it will be understood by one of ordinary skill in the art that variations in form and detail may be made therein without departing from the scope of the attached claims.

## Claims

1. A three-dimensional semiconductor device, comprising:
a back-side metal layer;
a lower active region on the back-side metal layer, the lower active region including a lower channel pattern and a lower source/drain pattern connected with the lower channel pattern;
an upper active region on the lower active region, the upper active region including an upper channel pattern and an upper source/drain pattern connected with the upper channel pattern;
an interlayer insulating layer that encloses the lower source/drain pattern and the upper source/drain pattern;
a penetration conductive pattern that extends through the interlayer insulating layer in a vertical direction; and
an inhibitor that covers a side surface of a lower portion of the penetration conductive pattern, wherein the inhibitor includes a carbon atom.

2. The three-dimensional semiconductor device of claim 1, wherein a bottom surface of the inhibitor is coplanar with a bottom surface of the penetration conductive pattern.

3. The three-dimensional semiconductor device of claim 1 or claim 2, comprising a device isolation layer between the back-side metal layer and the penetration conductive pattern,
wherein the penetration conductive pattern is in contact with the device isolation layer.

4. The three-dimensional semiconductor device of any preceding claim, comprising a lower contact pattern between the back-side metal layer and the penetration conductive pattern,
wherein the penetration conductive pattern is in contact with the lower contact pattern.

5. The three-dimensional semiconductor device of any preceding claim, comprising a penetration spacer that extends between the penetration conductive pattern and the interlayer insulating layer.

6. The three-dimensional semiconductor device of claim 5, wherein the penetration spacer separates the penetration conductive pattern from the interlayer insulating layer.

7. The three-dimensional semiconductor device of claim 5 or claim 6, wherein the inhibitor is disposed between the lower portion of the penetration conductive pattern and the penetration spacer.

8. The three-dimensional semiconductor device of any of claims 1-4, wherein a side surface of the penetration conductive pattern is in contact with the interlayer insulating layer.

9. The three-dimensional semiconductor device of any of claims 1-4 or claim 8, wherein a side surface of the inhibitor is in contact with the interlayer insulating layer.

10. The three-dimensional semiconductor device of any preceding claim, wherein the penetration conductive pattern includes at least one of molybdenum, rubidium, copper, aluminum, or tungsten.

11. The three-dimensional semiconductor device of any preceding claim, wherein a side surface of the inhibitor is aligned to a side surface of an upper portion of the penetration conductive pattern.

12. The three-dimensional semiconductor device of any preceding claim, wherein the inhibitor does not cover at least a portion of a bottom surface of the penetration conductive pattern.

13. A method of fabricating a three-dimensional semiconductor device, comprising:
forming a penetration hole that extends through an interlayer insulating layer, the interlayer insulating layer being on a device isolation layer;
forming an inhibitor on an inner side surface of the penetration hole, the inhibitor exposing a top surface of the device isolation layer to the penetration hole;
forming a seed layer that covers the exposed top surface of the device isolation layer; removing an upper portion of the inhibitor; and
growing a main layer using the seed layer as a seed to fill the penetration hole.

14. The method of claim 13, wherein the growing of the main layer includes gradually growing, in the penetration hole, the main layer from the seed layer toward an uppermost portion of the penetration hole.

15. The method of claim 13 or claim 14, wherein the forming of the inhibitor includes:
forming a penetration spacer that covers an inner surface of the penetration hole;
removing the penetration spacer from an inner bottom surface of the penetration hole to expose the device isolation layer; and
depositing the inhibitor on the inner side surface of the penetration hole to cover the penetration spacer,
wherein the inhibitor is selectively deposited on the inner side surface of the penetration hole.
